# EUROPEAN PATENT APPLICATION

(11) **EP 4 773 484 A1**
(43) Date of publication of application: **08.07.2026**
(21) Application number: 24859592.8
(22) Date of filing: 22.08.2024
(51) Int. Cl.: H02K 11/33, B64D 27/24, B64U 50/19, H02K 5/00, H02K 9/06, H02M 7/48

(54) **DRIVE DEVICE**

(30) Priority: 01.09.2023 JP 2023142445
(71) Applicant: DENSO CORPORATION, Kariya-city, Aichi 448-8661 (JP)
(72) Inventor: ICHIHASHI, Katsuhiro, Nisshin-city, Aichi 470-0111 (JP); NAGAI, Shohei, Nisshin-city, Aichi 470-0111 (JP)
(74) Representative: TBK
(86) International application number: PCT/JP2024/029788
(87) International publication number: WO 2025/047559

(57) **Abstract**

An inverter device (80) includes an inverter housing (90) and an inverter unit (170). The inverter unit (170) is housed in the inverter housing (90). The inverter housing (90) includes a first fin (921) and a second fin (922) disposed thereon. The first fin (921) and the second fin (922) are arranged along an inverter outer periphery surface (910) in an axial direction (AD). The first fin (921) and the second fin (922) extend in the axial direction (AD) from a radially-aligned position of the inverter unit (170) in the radial direction (RD). The first fin (921) extends upstream from the inverter unit (170). The second fin (922) extends downstream from the inverter unit (170).

## Description

### CROSS REFERENCE TO RELATED APPLICATION

The present application is based on Japanese Patent Application No. 2023-142445 filed on September 01, 2023. The entire disclosures of all of the above applications are incorporated herein by reference.

### TECHNICAL FIELD

Te present disclosure relates to a drive device.

### BACKGROUND ART

Patent Literature 1 describes a drive unit provided with heat dissipation fins. In the drive device, multiple heat dissipation fins are provided on the outer surface of the housing. The heat dissipation fins extend in a serpentine pattern along the outer surface of the housing. Patent Literature 1 states that the serpentine shape of the heat dissipation fins facilitates generation of turbulence in the air flowing between two adjacent heat dissipation fins, thereby improving heat dissipation capacity of the heat dissipation fins.

### PRIOR ART LITERATURE

### PATENT LITERATURE

Patent Literature 1: JP2008-186820A

### SUMMARY OF INVENTION

However, in the above-mentioned Patent Literature 1, since the entire heat dissipation fin is meandering, it is thought that pressure loss increases between two adjacent heat dissipation fins. If the pressure loss increases, the amount of air flowing between two adjacent heat dissipation fins will decrease, which may reduce the heat dissipation effect of the heat dissipation fins.

It is an object of the present disclosure to provide a drive device that can improve the heat dissipation effect of the housing.

Disclosed aspects in this specification adopt different technical solutions from each other in order to achieve their respective objectives. Reference numerals in parentheses in the claims and the section are an example indicating a correspondence relationship with specific means described in an embodiment to be described later as one aspect, and do not limit the technical scope.

In order to achieve the above object, a disclosed aspect is a drive device configured to be driven by electric power. The drive device comprises: a heat generating portion configured to generate heat when energized; a housing having an outer peripheral surface, which extends in an axial direction, and accommodating the heat generating portion; and a plurality of outer peripheral fins extending in the axial direction along the outer peripheral surface of the housing, arranged in a circumferential direction of the housing along the outer peripheral surface of the housing, and configured to dissipate heat from the heat generating portion to an outside of the housing. The outer peripheral surface includes, as a pair of ends aligned in the axial direction, a first surface end and a second surface end. The peripheral fins include: a first outer peripheral fin extending from a position, which is aligned with the heat generating portion in a radial direction of the housing, toward the first surface end among the first surface end and the second surface end; and a second outer peripheral fin provided at a position spaced apart from the first outer peripheral fin in a direction perpendicular to the radial direction, the second outer peripheral fin extending from a position, which is aligned with the heat generating portion in the radial direction, toward the second surface end among the first surface end and the second surface end.

According to the above aspect, the first outer peripheral fin and the second outer peripheral fin are provided at positions spaced apart in a direction perpendicular to the axial direction. In such configuration, turbulence such as vortices is likely to occur in the gas such as air flowing through the space between the first outer peripheral fin and the second outer peripheral fin at positions radially aligned with the heat generating portion. Therefore, the heat dissipation effect for dissipating heat of the heat generating portion from the first outer peripheral fin, the second outer peripheral fin and the outer peripheral surface of the housing can be improved by the turbulence of the gas. In such manner, localized gas turbulence occurs at a position radially aligned with the heat generating portion on the outside of the housing, thereby preventing an increase in pressure loss throughout the entire space between two circumferentially adjacent outer fins. Therefore, it is possible to prevent the amount of gas flowing between two circumferentially adjacent outer peripheral fins from becoming insufficient, while enhancing the heat dissipation effect of the gas from the heat-generating portion. As described above, the heat dissipation effect of the housing in the drive unit is improvable by the outer peripheral fins.

### BRIEF DESCRIPTION OF THE DRAWINGS

FIG. 1 is a diagram of a configuration of an eVTOL according to a first embodiment.
FIG. 2 is a diagram of an electrical configuration of a propulsion system.
FIG. 3 is a side view of a propulsion device.
FIG. 4 is a plan view of an inverter device.
FIG. 5 is a cross-sectional view along a line V - V in FIG. 3.
FIG. 6 is a cross-sectional view along a line VI - VI in FIG. 4, and is a vertical cross-sectional view of the inverter device.
FIG. 7 is an enlarged side view of a switch component in the inverter device.
FIG. 8 is a diagram for explaining a thermal boundary layer.
FIG. 9 is an enlarged side view of a proximity of a motor radial line in the inverter device.
FIG. 10 is an enlarged side view of the switch component in the inverter device according to a second comparative example.
FIG. 11 is an enlarged side view of a proximity of a switch component in an inverter device according to a second comparative example.
FIG. 12 is an enlarged side view of a proximity of a motor radial line in the inverter device according to the second embodiment.
FIG. 13 is an enlarged side view of a proximity of the motor radial line in the inverter device according to a third embodiment.
FIG. 14 is a plan view of the inverter device according to a fourth embodiment.
FIG. 15 is a cross-sectional view along a line XV - XV in FIG. 16.
FIG. 16 is a cross-sectional view along a line XVI - XVI in FIG. 14.
FIG. 17 is a cross-sectional view along a line XVII - XVII in FIG. 16.

### DESCRIPTION OF EMBODIMENTS

The embodiments for carrying out the present disclosure are described in the following with reference to the drawings. In each of the embodiments, parts corresponding to the elements described in the preceding embodiments are denoted by the same reference numerals, and redundant explanation may be omitted. When only a part of the configuration is described in one embodiment, previously described embodiment(s) may be applicable to the other parts of the configuration. It may be possible not only to combine parts the combination of which is explicitly described in an embodiment, but also to combine parts of respective embodiments the combination of which is not explicitly described when such combination of parts is not particularly hindered.

### <First Embodiment>

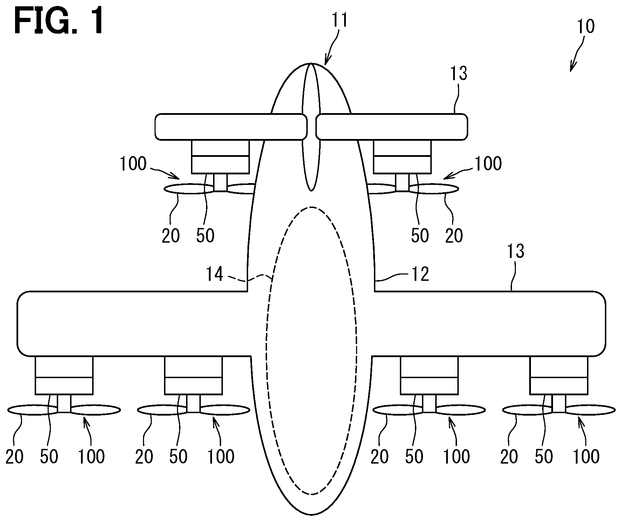

An eVTOL 10 shown in FIG. 1 is an electric vertical take-off and landing flight vehicle. The electric vertical take-off and landing flight vehicle is an electric-powered vertical take-off and landing flight vehicle, and can take off and land vertically. The eVTOL is an abbreviation of electric vertical take-off and landing flight vehicle. The eVTOL 10 is an electric-powered flight vehicle that flies through the atmosphere, and may be referred to as an electric flight vehicle. The eVTOL 10 is also an electric-powered flight vehicle, and may be referred to as an electric flight vehicle. The eVTOL 10 is a manned flight vehicle carrying an occupant. The occupant of the eVTOL 10 includes a pilot acting as an operator or a driver.

The eVTOL 10 includes an airframe 11 and propellers 20. The airframe 11 includes an airframe main body 12 and wings 13. The airframe main body 12 is a body of the airframe 11 and has, for example, a shape extending in a front-rear direction. The airframe main body 12 has an occupant compartment 14 for carrying occupants. Each of the wings 13 extends from the airframe main body 12, and multiple wings 13 are provided on the airframe main body 12. The wings 13 are fixed wings. The multiple wings 13 include a main wing, a tail wing, and the like.

The eVTOL 10 has a cabin. The cabin is provided inside the eVTOL 10. For example, the cabin is an internal space of the airframe main body 12 and is formed by the airframe main body 12. Examples of the cabin include the occupant compartment 14, and a cargo compartment. Examples of the occupant compartment 14 include a passenger compartment, a pilot compartment and the like. Seats for the occupants to sit are provided in the occupant compartment 14. The occupant compartment 14 may be not occupied by the occupants, and may accommodate cargo.

The propellers 20 are provided on the airframe 11. The eVTOL 10 is a multicopter including at least three propellers 20. For example, at least six propellers 20 are provided on the airframe 11. The propellers 20 are provided on each of the airframe main body 12 and the wings 13. Each of the propellers 20 rotates about a propeller axis thereof. The propeller axis is, for example, a center line of the propeller 20. The propeller 20 can generate thrust and lift in the eVTOL 10. The propeller 20 may be referred to as a rotor or a rotary wing.

In the eVTOL 10, by providing multiple propellers 20, balance of the airframe is easily maintained. Even when a propeller output of one of the propellers 20 unintentionally lowers, the eVTOL 10 can continue to fly using the remaining propellers 20. Examples of the propeller output include a rotation speed and a torque of the propeller 20.

The propeller 20 includes blades, a boss, and a propeller shaft. The blades are arranged in a circumferential direction of the propeller axis. The boss couples the multiple blades. The propeller shaft is a rotating shaft of the propeller 20, and extends along the propeller axis from the boss.

Examples of a flight mode of the eVTOL 10 include vertical take-off, vertical landing, cruise, hovering, and the like. The flight mode may be referred to as a flight behavior. During the vertical take-off, the eVTOL 10 can take off without using a runway. During the vertical take-off, the eVTOL 10 may rise in the vertical direction, or may rise obliquely upward. During the vertical landing, the eVTOL 10 can land without using the runway. During the vertical landing, the eVTOL 10 may descend in the vertical direction, or may descend obliquely downward.

The cruise may be referred to as horizontal flight. During the cruise, the eVTOL 10 may fly in a horizontal direction without moving in an up-down direction, or may fly in the horizontal direction while moving in the up-down direction. The hovering may be referred to as hovering flight. During the hovering, the eVTOL 10 may fly as if stopping at a predetermined position in the air, or the eVTOL 10 may move from a predetermined position in the up-down direction or in the horizontal direction.

The flight mode of the eVTOL 10 includes lift. During the lift, the eVTOL 10 moves in the up-down direction. As the lift, the eVTOL 10 may ascend obliquely upward, or may descend obliquely downward. The eVTOL 10 takes off vertically when lifting upward. The eVTOL 10 lands vertically when lifting downward.

The eVTOL 10 is a tilt-rotor flight vehicle. In the eVTOL 10, a tilt angle of the propeller 20 is adjustable. In the eVTOL 10, one propeller 20 can function as both of a propeller for the lift and a propeller for the cruise. For example, when the eVTOL 10 is lifting, the tilt angle is adjusted such that the propeller 20 functions as a lift-rotor. When the eVTOL 10 is cruising, the tilt angle is adjusted such that the propeller 20 functions as a cruise-rotor. Note that the eVTOL 10 may be not a tilt-rotor flight vehicle. For example, the eVTOL 10 may include the propeller 20 for the lift and the propeller 20 for the cruise, which are separate propellers from each other.

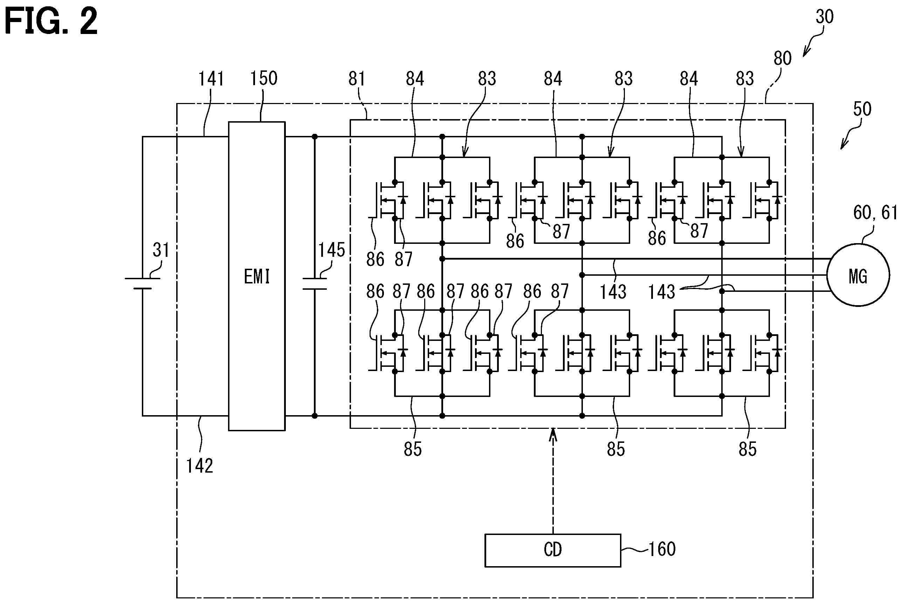

A propulsion system 30 shown in FIG. 2 is mounted on the eVTOL 10. The propulsion system 30 is a system that is driven to propel the eVTOL 10. The propulsion system 30 includes a battery 31 and an EPU 50. The battery 31 and the EPU 50 are mounted on the EPU 50. Note that the propulsion system 30 includes a flight control device (not shown). The flight control device performs flight control to fly the eVTOL 10. In flight control, the propulsion system 30 and the EPU 50 are controlled.

The battery 31 is electrically connected to the EPU 50 for energizing thereof. The battery 31 is a power supply unit that supplies electric power to the EPU 50, and corresponds to a power source. The battery 31 is a DC voltage source that applies a DC voltage to the EPU 50. The battery 31 include a rechargeable secondary battery. Examples of the secondary battery include a lithium-ion battery, a nickel-hydrogen battery and the like. The battery 31 can store electric power, and corresponds to a power storage device. As the power source, a fuel cell, a generator, or the like may be used in addition to or instead of the battery 31.

In FIGs. 1 and 2, the EPU 50 is a device that is driven by electric power, and corresponds to a drive device. The EPU 50 drives the propeller 20 to rotate. The EPU is an abbreviation of Electric Propulsion Unit. The EPU 50 may be referred to as a power drive device or a power drive system. The EPU 50 is provided individually for each of the multiple propellers 20. The EPU 50 is aligned with the propeller 20 along the propeller axis. All of the multiple EPUs 50 are fixed on the airframe 11. The EPU 50 rotatably supports the propeller 20. The EPU 50 is connected to the propeller 20. The propeller 20 is fixed to the airframe 11 with the EPU 50 interposed therebetween.

As shown in FIG. 1, the eVTOL 10 includes propulsion devices 100. Each of the propulsion devices 100 includes the propeller 20 and the EPU 50. The propulsion device 100 is a device for propelling the eVTOL 10. The propulsion device 100 rotates the propeller 20 to cause the eVTOL 10 to fly. The eVTOL 10 is also a moving object that moves by using the propulsion devices 100. Multiple propulsion devices 100 are provided on the eVTOL 10. One propulsion device 100 includes one propeller 20 and one EPU 50 for driving the propeller 20. Note that, among the propeller 20 and the EPU 50, the EPU 50 alone may be referred to as the propulsion device 100.

The EPU 50 includes a motor device 60 and an inverter device 80. The motor device 60 includes a motor 61 and a motor housing 70. The motor housing 70 is a case, and accommodates the motor 61. The motor 61 is a multi-phase AC motor. The motor 61 is a rotary electric machine of a multi-phase AC type. The motor 61 is a flight driving source of the eVTOL 10, and functions as an electric motor. The motor 61 is a motor generator. The motor 61 functions as a generator during regeneration. As the motor 61, for example, a brushless motor is used.

The motor 61 drives and rotates the propeller 20 to enable the eVTOL 10 to fly. The motor 61 is a flight-motor causing the eVTOL 10 to fly. The motor 61 is powered by battery power to drive the propeller 20 to rotate. The battery power is electric power supplied from the battery 31 to the motor 61.

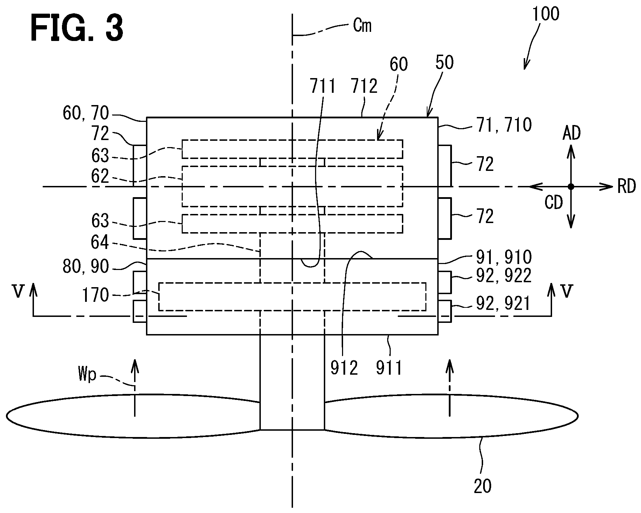

As shown in FIG. 3, the motor 61 includes a motor stator 62, a motor rotor 63, and a motor shaft 64. The motor stator 62 is a stator, and is fixed to the motor housing 70. The motor rotor 63 is rotated relative to the motor stator 62. Rotation of the motor rotor 63 may be referred to as rotation of the motor 61. The motor shaft 64 rotates together with the motor rotor 63. The motor shaft 64 is rotatably supported by the motor housing 70 or the like. The motor shaft 64 is connected to the propeller 20. In the propulsion device 100, the propeller 20 rotates together with the motor shaft 64.

The motor 61 is, for example, an axial gap-type motor. In the motor 61, the motor stator 62 and the motor rotor 63 are arranged in an axial direction AD along a motor axis Cm. The motor 61 is a dual-rotor motor. In the motor 61, two motor rotors 63 are arranged in the axial direction AD via the motor stator 62.

The motor axis Cm is a center line of the motor 61, and is a virtual line extending linearly. The motor rotor 63 rotates about the motor axis Cm. The motor axis Cm corresponds to a rotation axis. The axial direction AD is a direction along which the motor axis Cm extends. Regarding the motor axis Cm, the axial direction AD, a circumferential direction CD, and a radial direction RD are orthogonal to one another. The circumferential direction CD is a rotation direction of the motor 61. Regarding the radial direction RD, an outer side may be referred to as a radially outer side or an outer periphery side, and an inner side may be referred to as a radially inside or a radially inner side.

The inverter device 80 supplies electric power to the motor device 60 to drive the motor device 60. The inverter device 80 is a driving unit for driving the motor 61, and corresponds to a motor driving unit. The inverter device 80 includes an inverter unit 170 and an inverter housing 90. The inverter housing 90 is a housing that houses the inverter unit 170. The inverter unit 170 is capable of converting electric power. In the inverter unit 170, the electric power supplied from the battery 31 to the motor 61 is converted. The inverter unit 170 is formed in a plate shape as a whole. The inverter unit 170 extends in a direction perpendicular to the axial direction AD.

The motor device 60 and the inverter device 80 are aligned in the axial direction AD. For example, the inverter device 80 is provided at a position between the motor device 60 and the propeller 20 in the axial direction AD. The motor shaft 64 is connected to the propeller 20 while passing through the inverter device 80 in the axial direction AD.

As shown in FIG. 2, the inverter device 80 includes an inverter circuit 81, a smoothing capacitor 145, a filter circuit 150, and a control circuit 160. In FIG. 2, the motor 61 is shown as MG, the filter circuit 150 as EMI, and the control circuit 160 as CD.

The propulsion system 30 includes a P line 141, an N line 142 and an output line 143. The P line 141 and the N line 142 electrically connect the battery 31 and the inverter circuit 81 for energizing thereof. The P line 141 and the N line 142 are formed by bus bars, electrical wiring, or the like. At least a portion of the P line 141 and at least a portion of the N line 142 are included in the inverter device 80.

The P line 141 is electrically connected to the positive electrode of the battery 31 for energizing therefrom. The N line 142 is electrically connected to the negative electrode of the battery 31 for energizing therefrom. In the battery 31, the positive electrode is an electrode on a high potential side, and the negative electrode is an electrode on a low potential side. The P line 141 and the N line 142 are power lines for supplying the electric power of the battery 31 to the inverter circuit 81. The P line 141 is a power line on the high potential side, and may be referred to as a high potential line. The N line 142 is a power line on the low potential side, and may be referred to as a low potential line.

The output line 143 is a power line for supplying electric power from the inverter circuit 81 to the motor 61. The output line 143 electrically connects the motor 61 and the inverter circuit 81 for energizing thereof. For example, the output line 143 is electrically connected to the motor stator 62 for energizing thereof. The output line 143 is formed by a bus bar, an electric wiring, or the like. At least a portion of the output line 143 is included in the inverter device 80.

The smoothing capacitor 145 is a capacitor that smooths the DC voltage supplied from the battery 31. The smoothing capacitor 145 is connected to the P line 141 and the N line 142 at a position between the battery 31 and the inverter circuit 81. The smoothing capacitor 145 is connected in parallel to the inverter circuit 81.

The filter circuit 150 is a circuit for reducing noise such as electromagnetic noise and the like. The filter circuit 150 may be an EMI filter or the like. The filter circuit 150 is provided at a position between the smoothing capacitor 145 and the battery 31. The filter circuit 150 is connected in parallel to the inverter circuit 81 with respect to the battery 31. The filter circuit 150 includes a choke coil and a filter capacitor. The choke coil includes a common mode coil and a normal mode coil. The filter capacitors include a Y capacitor and an X capacitor.

The inverter circuit 81 is a circuit for converting electric power. The inverter circuit 81 performs power conversion for each of the multiple phases. The inverter circuit 81 converts DC power from the battery 31 into AC power, and supplies the AC power to the motor 61. For example, the inverter circuit 81 is a DC-AC conversion circuit.

The inverter circuit 81 includes upper and lower arm circuits 83 for a plurality of phases. For example, the inverter circuit 81 includes upper and lower arm circuits 83 for each of the U-phase, V-phase, and W-phase. The upper and lower arm circuit 83 includes an upper arm 84 and a lower arm 85. The upper arm 84 and the lower arm 85 are connected in series to the battery 31. The output line 143 is connected at a position between the upper arm 84 and the lower arm 85 in the upper and lower arm circuit 83. The upper arm 84 is connected to the P line 141 and the output line 143. The lower arm 85 is connected to the N line 142 and the output line 143.

The upper arm 84 and the lower arm 85 each have an arm switch 86 and an arm diode 87. The arm switch 86 is formed of a semiconductor switch or the like. The semiconductor switch is a switch that does not have mechanical contacts. The arm switch 86 is a transistor such as a MOSFET, an IGBT or the like. The MOSFET is an abbreviation of a metal-oxide-semiconductor field-effect transistor. The IGBT is an abbreviation of an insulated gate bipolar transistor. The arm switch 86 is a switching element that can convert electric power by switching. The switching element is a semi-conductor element such as a power element or the like. The arm switch 86 is a conversion switch for converting electric power.

The arm diode 87 is a freewheeling diode. The arm diode 87 is connected in anti-parallel to the arm switch 86. The arm diode 87 may be a parasitic diode of the arm switch 86, or may be a diode provided separately from the parasitic diode.

The control circuit 160 performs motor control for controlling the motor 61. The motor control includes control of the inverter circuit 81 and the like. The control circuit 160 is a control device such as an ECU or the like. The control circuit 160 may be referred to as an inverter control unit or a motor control unit. The control circuit 160 is communicatively connected to the inverter circuit 81. The control circuit 160 outputs an instruction signal to control the motor via the inverter circuit 81.

The inverter device 80 includes a drive circuit. The drive circuit is a circuit for driving the inverter circuit 81. The control circuit 160 is communicatively connected to the inverter circuit 81 via the drive circuit. The drive circuit is electrically connected to the arm switch 86 for energizing thereof. The drive circuit generates a drive voltage in response to the instruction signal from the control circuit 160. The drive circuit applies the drive voltage to the arm switch 86 to drive the arm switch 86.

In FIG. 3, in the propulsion device 100, a propeller wind Wp is generated as the propeller 20 rotates. The propeller wind Wp flows in the axial direction AD as a whole. The propeller wind Wp is an airflow generated by the flow of gas such as air. The gas that generates the airflow such as the propeller wind Wp and the like is sometimes called as a refrigerant. In the present embodiment, the propeller wind Wp flows from the propeller 20 toward the EPU 50. In the EPU 50, the propeller wind Wp flows from the inverter device 80 toward the motor device 60. With respect to the propeller wind Wp, the inverter device 80 is positioned upstream of the motor device 60.

The motor housing 70 includes a motor housing body 71 and motor fins 72. The motor housing body 71 and the motor fins 72 are made of a metal material or the like, and have thermal conductivity. The motor housing body 71 forms inner and outer surfaces of the motor housing 70. The outer surface of the motor housing body 71 includes a motor outer peripheral surface 710, a motor upstream surface 711, and a motor downstream surface 712. The motor outer peripheral surface 710 is formed in an annular shape, and extends in the axial direction AD. The motor 61 is accommodated on a radially inner side of the motor outer peripheral surface 710.

The motor upstream surface 711 and the motor downstream surface 712 are aligned in the axial direction AD via the motor outer peripheral surface 710. The motor upstream surface 711 and the motor downstream surface 712 extend in a direction perpendicular to the axial direction AD. The motor upstream surface 711 and the motor downstream surface 712 cover the motor 61 in the axial direction AD. With respect to the propeller wind Wp, the motor upstream surface 711 is positioned upstream of the motor downstream surface 712.

The motor fins 72 are provided on the outer surface of the motor housing 70. The motor fins 72 are heat dissipation fins for dissipating heat from the motor device 60 to the outside. The motor fin 72 is formed in a plate shape, and extends in a direction perpendicular to the circumferential direction CD. The motor fins 72 are provided on the motor outer peripheral surface 710 of the motor. The motor fins 72 extend toward an outer periphery from the motor outer peripheral surface 710. The motor fins 72 extend in the axial direction AD along the motor outer peripheral surface 710. A plurality of motor fins 72 are arranged in the circumferential direction CD along the motor outer peripheral surface 710. Further, the motor fins 72 are arranged in a plurality in the axial direction AD along the motor outer peripheral surface 710.

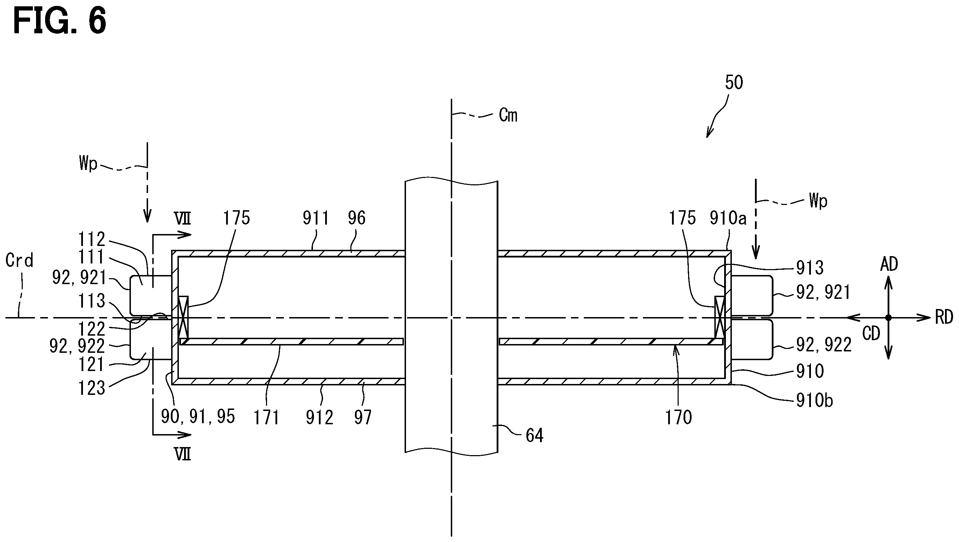

As shown in FIGs. 3 and 6, the inverter housing 90 includes an inverter housing body 91 and inverter fins 92. The inverter housing body 91 and the inverter fins 92 are made of a metal material or the like, and have thermal conductivity. The inverter housing body 91 forms the inner and outer surfaces of the inverter housing 90. The outer surface of the inverter housing body 91 includes an inverter outer peripheral surface 910, an inverter upstream surface 911, an inverter downstream surface 912, and an inverter inner peripheral surface 913. The inverter outer peripheral surface 910 and the inverter inner peripheral surface 913 are formed in an annular shape, and extend in the axial direction AD. The inverter housing 90 corresponds to a housing. The inverter outer peripheral surface 910 corresponds to an outer peripheral surface of the housing. The inverter inner peripheral surface 913 corresponds to an inner peripheral surface of the housing. In FIG. 6, the motor housing 70 and the like are omitted from the illustration.

The inverter outer peripheral surface 910 includes a pair of ends aligned in the axial direction AD, that is, an outer peripheral upstream end 910a and an outer peripheral downstream end 910b. The outer peripheral upstream end 910a is one of a pair of ends of the inverter outer peripheral surface 910 on an inverter upstream surface 911 side. The outer peripheral upstream end 910a extends in the circumferential direction CD along an outer peripheral edge of the inverter upstream surface 911. The outer peripheral upstream end 910a corresponds to a first surface end. The outer peripheral downstream end 910b is one of a pair of ends of the inverter outer peripheral surface 910 on an inverter downstream surface 912 side. The outer peripheral downstream end 910b extends in the circumferential direction CD along the outer peripheral edge of the inverter downstream surface 912. The outer peripheral downstream end 910b corresponds to a second surface end.

The inverter upstream surface 911 and the inverter downstream surface 912 are aligned in the axial direction AD via the inverter outer peripheral surface 910. The inverter upstream surface 911 and the inverter downstream surface 912 extend in a direction perpendicular to the axial direction AD. The inverter upstream surface 911 and the inverter downstream surface 912 cover the inverter unit 170 in the axial direction AD. The inverter upstream surface 911 corresponds to a housing cover surface. With respect to the propeller wind Wp, the inverter upstream surface 911 is positioned upstream of the inverter downstream surface 912.

In the EPU 50, the motor upstream surface 711 and the inverter downstream surface 912 are overlapped with each other. In the EPU 50, the motor outer peripheral surface 710 and the inverter outer peripheral surface 910 are aligned in axial direction AD. With respect to the propeller wind Wp, the inverter upstream surface 911 is provided upstream of the motor downstream surface 712.

The inverter housing body 91 includes an inverter outer peripheral wall 95, an inverter upstream wall 96, and an inverter downstream wall 97. The inverter outer peripheral wall 95 forms the inverter outer peripheral surface 910 and the inverter inner peripheral surface 913. The inverter outer peripheral surface 910 is an outer peripheral surface of the inverter outer peripheral wall 95. The inverter inner peripheral surface 913 is an inner peripheral surface of the inverter outer peripheral wall 95. The inverter outer peripheral wall 95 is formed in a cylindrical shape, and extends in the axial direction AD. The inverter unit 170 is housed on a radially inner side of the inverter outer peripheral wall 95.

The inverter upstream wall 96 forms the inverter upstream surface 911. The inverter upstream surface 911 is an outer surface of the inverter upstream wall 96. The inverter downstream wall 97 forms the inverter downstream surface 912. The inverter downstream surface 912 is an outer surface of the inverter downstream wall 97. The inverter upstream wall 96 and the inverter downstream wall 97 are aligned in the axial direction AD via the inverter outer peripheral wall 95. The inverter upstream wall 96 and the inverter downstream wall 97 extend in a direction perpendicular to the axial direction AD. The inverter upstream wall 96 and the inverter downstream wall 97 cover the inverter unit 170 in the axial direction AD. The inverter upstream wall 96 and the inverter downstream wall 97 close off an inner space of the inverter outer peripheral wall 95 from the axial direction AD. With respect to the propeller wind Wp, the inverter upstream wall 96 is positioned upstream of the inverter downstream wall 97.

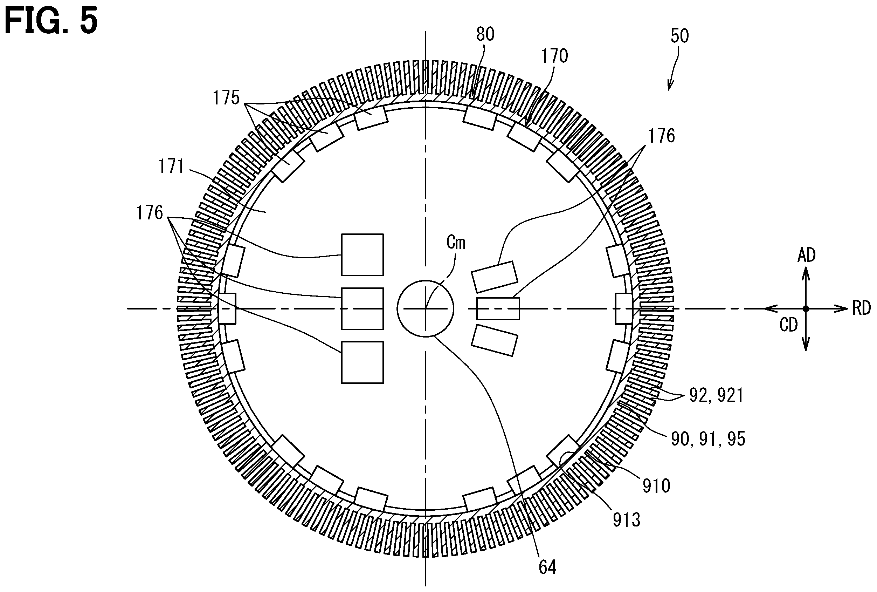

In FIGs. 5 and 6, the inverter unit 170 includes the inverter circuit 81, the smoothing capacitor 145, the filter circuit 150, the control circuit 160, and the like. The inverter unit 170 includes an inverter substrate 171, a switch component 175, a capacitor component 176, and a filter component 177. The inverter substrate 171 is a circuit board. The inverter substrate 171 extends along the inverter upstream wall 96 and the inverter downstream wall 97 in a direction perpendicular to the axial direction AD. The inverter substrate 171 is provided at a position between the inverter upstream wall 96 and the inverter downstream wall 97. In the axial direction AD, a distance between the inverter substrate 171 and the outer peripheral upstream wall 96a is greater than a distance between the inverter substrate 171 and the inner peripheral upstream wall 96b.

The switch component 175, the capacitor component 176, and the filter component 177 are electric components or electronic components. The components 175 to 177 are mounted on the inverter substrate 171 as mounted components. The components 175 to 177 protrude from the inverter substrate 171 toward the inverter upstream wall 96. At least a portion of each of the components 175 to 177 is provided at a position between the inverter substrate 171 and the inverter upstream wall 96. In FIG. 6, the capacitor components 176, the filter components 177, and the like are omitted from the illustration.

The switch component 175 is a component that forms the arm switch 86. The capacitor component 176 is a component that forms the smoothing capacitor 145. The filter component 177 is a component for forming the filter circuit 150. The filter component 177 includes components that form a choke coil and components that form a filter capacitor. Note that the capacitor component 176 may also be a component that forms a filter capacitor.

A plurality of switch components 175 are arranged in the circumferential direction CD along the inverter inner peripheral surface 913. The switch component 175 is provided on the inverter inner peripheral surface 913. The switch component 175 corresponds to a surface-mount component. The switch component 175 is fixed to at least one of the inverter substrate 171 and the inverter inner peripheral surface 913. The switch component 175 is provided on the inverter inner peripheral surface 913 in a state in which heat is transferrable from the switch component 175 to the inverter outer peripheral wall 95. For example, the switch component 175 is fixed to the inverter outer peripheral wall 95 with a fastener such as a screw while being in a contact state with the inverter inner peripheral surface 913. Note that the switch component 175 may be provided on the inverter inner peripheral surface 913 via a heat transfer gel or a fixing member.

The switch component 175 is provided at a position between the outer peripheral upstream end 910a and the outer peripheral downstream end 910b in the axial direction AD. The switch component 175 is provided at a position spaced apart from both of the inverter upstream wall 96 and the inverter downstream wall 97. The switch component 175 is provided at a position where an outer periphery center line Crd passes. For example, the outer periphery center line Crd passes through the center of the switch component 175. The outer periphery center line Crd is a center line passing through the center of the inverter outer peripheral surface 910 in the axial direction AD. The outer periphery center line Crd passes through (a) the center of the outer peripheral upstream end 910a and (b) the center of the outer peripheral downstream end 910b. The outer periphery center line Crd is an imaginary line that extends linearly. The outer periphery center line Crd is perpendicular to the motor axis Cm.

The capacitor component 176 and the filter component 177 are provided on a radially inner side of the switch component 175. For example, the capacitor component 176 and the filter component 177 are provided at positions spaced apart from the switch component 175 on the inner circumferential side. The capacitor component 176 and the filter component 177 correspond to an inner circumference component. The capacitor component 176 and the filter component 177 are provided at positions spaced apart from the motor shaft 64 o a radially outer side.

In the EPU 50, the motor device 60 and the inverter device 80 generate heat as the motor 61 is driven. In the motor device 60, the motor 61 and other components generate heat when the motor 61 is energized. In the inverter device 80, the inverter unit 170 generates heat as a result of energization of the inverter unit 170. For example, in the inverter device 80, when energizing the arm switch 86, the smoothing capacitor 145, and the filter circuit 150, heat generation occurs in the switch component 175, the capacitor component 176, the filter component 177, and the like. The inverter unit 170 corresponds to a heat generating portion. The switch component 175, the capacitor component 176, and the filter component 177 correspond to heat-generating components.

Note that the control circuit 160 and the drive circuit may be formed on the inverter substrate 171 or may be formed on a circuit board other than the inverter substrate 171. For example, the other circuit boards are housed in the inverter housing 90 together with the inverter substrate 171, for example, by being arranged next to the inverter substrate 171 in the axial direction AD.

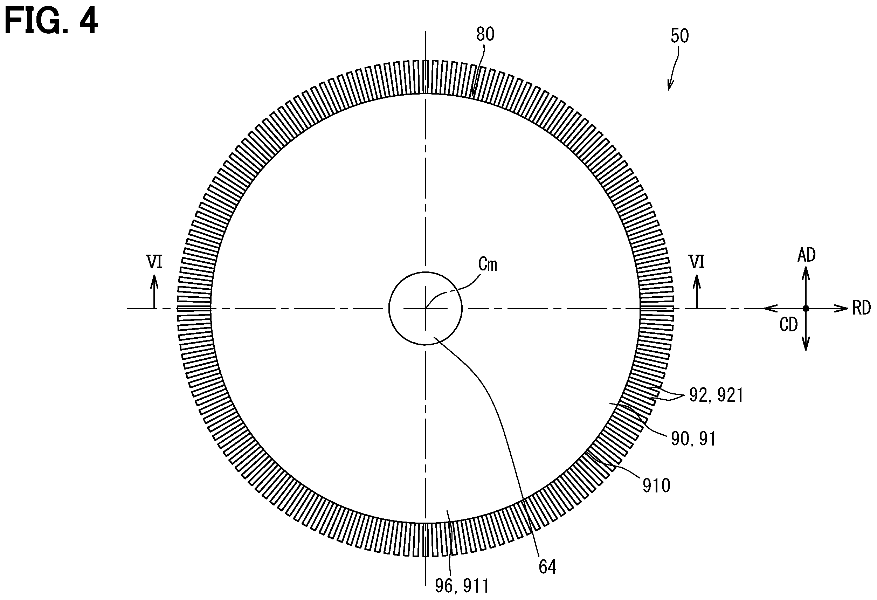

As shown in FIGs. 3 and 6, the inverter fins 92 are provided on an outer surface of the inverter housing 90. The inverter fins 92 are heat dissipation fins for dissipating heat from the inverter device 80 to the outside. The inverter fins 92 are formed in a plate shape, and extend in a direction perpendicular to the circumferential direction CD. The inverter fins 92 are provided on the inverter outer peripheral surface 910. The inverter fins 92 extend from the inverter outer peripheral surface 910 toward the outer periphery. The inverter fins 92 extend in the axial direction AD along the inverter outer peripheral surface 910. The inverter fins 92 are arranged in a plurality in the circumferential direction CD along the inverter outer peripheral surface 910 (see FIGs. 4 and 5). The inverter fins 92 are arranged in a plurality in the axial direction AD along the inverter outer peripheral surface 910. The inverter fins 92 correspond to an outer peripheral fins.

The plurality of inverter fins 92 includes a first fin 921 and a second fin 922. The first fin 921 and the second fin 922 are included in the inverter housing 90. The first fin 921 and the second fin 922 are arranged in the axial direction AD along the inverter outer peripheral surface 910. The first fin 921 and the second fin 922 are spaced apart in a direction perpendicular to the radial direction RD. For example, the first fin 921 and the second fin 922 are spaced apart in the axial direction AD. The first fins 921 and the second fins 922 are arranged in plurals along the inverter outer peripheral surface 910 in the circumferential direction CD.

The first fin 921 is provided on an outer peripheral upstream end 910a side of the second fin 922. The first fin 921 is provided at a position between the second fin 922 and the outer peripheral upstream end 910a in the axial direction AD. The first fin 921 is provided on an outer peripheral upstream end 910a side of the outer periphery center line Crd. The first fin 921 may also be referred to as an upstream fin.

The second fin 922 is provided at a position between the first fin 921 and the outer peripheral downstream end 910b in the axial direction AD. The second fin 922 is provided on an outer peripheral downstream end 910b side of the outer periphery center line Crd. With respect to the propeller wind Wp, the first fin 921 is positioned upstream of the second fin 922. The second fin 922 may also be referred to as a downstream fin.

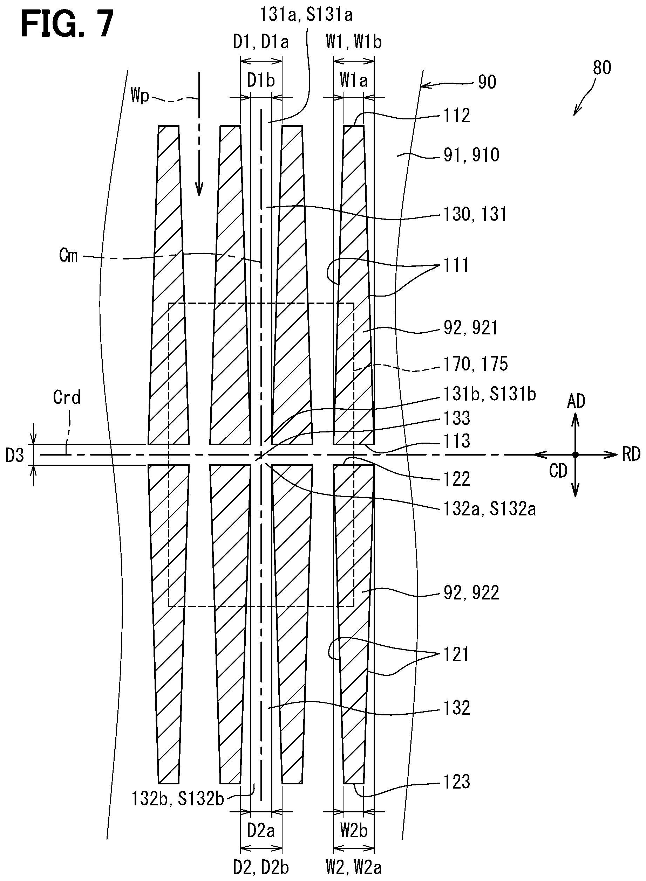

As shown in FIG. 7, the first fin 921 includes a pair of first fin surfaces 111. The first fin surface 111 is a plate surface of the first fin 921. The first fin surface 111 extends in a direction perpendicular to the circumferential direction CD. The pair of first fin surfaces 111 are aligned in the circumferential direction CD. The first fin surface 111 is also a side surface of the first fin 921, and may also be referred to as a fin side surface.

The first fin 921 includes a first upstream end 112 and a first downstream end 113 as a pair of ends aligned in the axial direction AD. The first upstream end 112 is an upstream end of the first fin 921. The first upstream end 112 is one of a pair of ends of the first fin 921 on an outer peripheral upstream end 910a side. The first upstream end 112 includes an end face extending in a direction perpendicular to the axial direction AD. The end face of the first upstream end 112 faces the outer peripheral upstream end 910a. The first downstream end 113 is a downstream end of the first fin 921. The first downstream end 113 is one of a pair of ends of the first fin 921 on an outer peripheral downstream end 910b side. The first downstream end 113 includes an end face extending in a direction perpendicular to the axial direction AD. The end face of the first downstream end 113 faces the outer peripheral downstream end 910b.

The first fin 921 has a shape in which a width in the circumferential direction CD gradually expands from the first upstream end 112 toward the first downstream end 113. The first fin 921 corresponds to an expanded fin. The first fin 921 continuously expands toward the first downstream end 113. A width dimension W1 of the first fin 921 gradually increases toward the first downstream end 113. The width dimension W1 corresponds to a width. The width dimension W1 is a width of the first fin 921 in the circumferential direction CD. In the first fin 921, a part where the width dimension W1 is smallest is the first upstream end 112. In the first fin 921, a part where the width dimension W1 is greatest is the first downstream end 113. A width dimension W1b of the first downstream end 113 is greater than a width dimension W1a of the first upstream end 112.

In the first fin 921, one of a pair of first fin surfaces 111 is inclined relative to the other. At least one of the pair of first fin surfaces 111 is inclined in the circumferential direction CD with respect to the motor axis Cm. For example, one of the pair of first fin surfaces 111 is inclined toward one side in the circumferential direction CD with respect to the motor axis Cm. The other one of the pair of first fin surfaces 111 is inclined toward the other side in the circumferential direction CD with respect to the motor axis Cm. The first fin 921 is formed in a tapered shape. The first fin surface 111 extends straight in the axial direction AD. The first fin surface 111 is a tapered surface.

Note that the first fin 921 may be expanded in stages toward the first downstream end 113. For example, the first fin surface 111 may be a stepped surface. Also, the first fin surface 111 may be curved to be recessed or bulged in the circumferential direction CD. For example, the first fin surface 111 may be a curved surface or a bent surface.

At least a portion of the first fin 921 is provided at a position aligned with the inverter unit 170 in the radial direction RD. The first fin 921 has the first downstream end 113 provided at a position aligned with the inverter unit 170 in the radial direction RD. The first fin 921 extends from the inverter unit 170 only toward the outer peripheral upstream end 910a, from among the outer peripheral upstream end 910a and the outer peripheral downstream end 910b. The first fin 921 corresponds to a first outer peripheral fin.

For example, at least a portion of the first fin 921 is provided at a position aligned with the switch component 175 in the radial direction RD. The first fin 921 has the first downstream end 113 provided at a position aligned with the switch component 175 in the radial direction RD. The first fin 921 extends only toward the outer peripheral upstream end 910a, from among the outer peripheral upstream end 910a and the outer peripheral downstream end 910b.

Regarding two adjacent first fins 921 in the circumferential direction CD, a first distance D1 therebetween gradually decreases from the first upstream end 112 toward the first downstream end 113. The first distance D1 is a distance between two first fins 921 adjacent to each other in the circumferential direction CD. The first distance D1 decreases continuously from the first upstream end 112 toward the first downstream end 113. The first distance D1 includes an upstream end distance D1a and a downstream end distance D1b. The upstream end distance D1a is a distance between two first upstream ends 112 adjacent to each other in the circumferential direction CD. The downstream end distance D1b is a distance between two first downstream ends 113 adjacent to each other in the circumferential direction CD. The downstream end distance D1b is smaller than the upstream end distance D1a. With regard to the first fin 921, the width dimension W1 gradually increases from the first upstream end 112 to the first downstream end 113, thereby the first distance D1 gradually decreases from the first upstream end 112 to the first downstream end 113.

The second fin 922 includes a pair of second fin surfaces 121. The second fin surface 121 is a plate surface of the second fin 922. The second fin surface 121 extends in a direction perpendicular to the circumferential direction CD. The pair of second fin surfaces 121 are aligned in the circumferential direction CD. The second fin surface 121 is also a side surface of the second fin 922, and may also be referred to as a fin side surface.

The second fin 922 has a second upstream end 122 and a second downstream end 123 as a pair of ends aligned in the axial direction AD. The second upstream end 122 is an upstream end of the second fin 922. The second upstream end 122 is one of the pair of ends of the second fin 922 on an outer peripheral upstream end 910a side. The second upstream end 122 includes an end face extending in a direction perpendicular to the axial direction AD. The end face of the second upstream end 122 faces the outer peripheral upstream end 910a. The second downstream end 123 is a downstream end of the second fin 922. The second downstream end 123 is one of a pair of ends of the second fin 922 on an outer peripheral downstream end 910b side. The second downstream end 123 includes an end face extending in a direction perpendicular to the axial direction AD. The end face of the second downstream end 123 faces the outer peripheral downstream end 910b.

The second fin 922 has a shape in which a width in the circumferential direction CD gradually shrinks from the second upstream end 122 to the second downstream end 123. The second fin 922 may also be referred to as a shrink fin. The second fin 922 continuously shrinks toward the second downstream end 123. A width dimension W2 of the second fin 922 gradually decreases toward the second downstream end 123. The width dimension W2 is a width of the second fin 922 in the circumferential direction CD. In the second fin 922, a part where the width dimension W2 is greatest is the second upstream end 122. In the second fin 922, a part where the width dimension W2 is smallest is the second downstream end 123. A width dimension W2b of the second downstream end 123 is smaller than a width dimension W2a of the second upstream end 122.

In the second fin 922, one of a pair of second fin surfaces 121 is inclined relative to the other. At least one of the pair of second fin surfaces 121 is inclined in the circumferential direction CD with respect to the motor axis Cm. For example, one of the pair of second fin surfaces 121 is inclined toward one side in the circumferential direction CD with respect to the motor axis Cm. The other one of the pair of second fin surfaces 121 is inclined toward the other side in the circumferential direction CD with respect to the motor axis Cm. The second fin 922 is formed in a tapered shape. The second fin surface 121 extends straight in the axial direction AD. The second fin surface 121 is a tapered surface.

Note that the second fin 922 may be expanded in stages toward the second downstream end 123. For example, the second fin surface 121 may be a stepped surface. Also, the second fin surface 121 may be curved to be recessed or bulged in the circumferential direction CD. For example, the second fin surface 121 may be a curved surface or a bent surface.

At least a portion of the second fin 922 is provided at a position aligned with the switch component 175 in the radial direction RD. The second fin 922 has the second upstream end 122 that is aligned with the switch component 175 in the radial direction RD. The second fin 922 extends from the first upstream end 112 only toward the outer peripheral downstream end 910b, from among the outer peripheral upstream end 910a and the outer peripheral downstream end 910b. The second fin 922 corresponds to a second outer peripheral fin.

Regarding two adjacent second fins 922 in the circumferential direction CD, a second distance D2 therebetween gradually increases from the second upstream end 122 toward the second downstream end 123. The second distance D2 is a distance between two second fins 922 adjacent to each other in the circumferential direction CD. The second distance D2 decreases continuously from the second upstream end 122 toward the second downstream end 123. The second distance D2 includes an upstream end distance D2a and a downstream end distance D2b. The upstream end distance D2a is a distance between two second upstream ends 122 adjacent to each other in the circumferential direction CD. The downstream end distance D2b is a distance between two second downstream ends 123 adjacent to each other in the circumferential direction CD. The downstream end distance D2b is greater than the upstream end distance D2a. With regard to the second fin 922, the width dimension W2 gradually decreases from the second upstream end 122 to the second downstream end 123, thereby the second distance D2 gradually increases from the second upstream end 122 to the second downstream end 123.

Regarding the first fin 921 and the second fin 922, the first downstream end 113 and the second upstream end 122 face each other. The first downstream end 113 and the second upstream end 122 are aligned in the axial direction AD. The first downstream end 113 and the second upstream end 122 are not shifted from each other in the circumferential direction CD. For example, one of the first downstream end 113 and the second upstream end 122 does not protrude from the other in the circumferential direction CD. Further, the width dimension W1b of the first downstream end 113 and the width dimension W2a of the second upstream end 122 are the same.

Athird distance D3 is greater than the downstream end distance D1b and the upstream end distance D2a. Further, the third distance D3 is smaller than the upstream end distance D1a and the downstream end distance D2b. The third distance D3 is a distance between the first fin 921 and the second fin 922 in the axial direction AD. Note that the third distance D3 may be smaller than or equal to the downstream end distance D1b and the upstream end distance D2a. Further, the third distance D3 may be greater than or equal to the upstream end distance D1a and the downstream end distance D2b.

In the inverter housing 90, a fin flow path 130 is formed by the plurality of inverter fins 92. The fin flow path 130 extends along the inverter outer peripheral surface 910 in a direction perpendicular to the radial direction RD. The fin flow path 130 extends along the outer surfaces of the inverter fins 92 in the axial direction AD and in the circumferential direction CD. The fin flow paths 130 are open toward the upstream side, downstream side, and radially outer side. For example, the fin flow paths 130 are open in the axial direction AD toward the outer peripheral upstream end 910a and the outer peripheral downstream end 910b. The fin flow paths 130 are open toward an opposite side from the inverter outer peripheral surface 910.

The fin flow path 130 includes a first flow path 131, a second flow path 132, and a connecting flow path 133. The first flow path 131, the second flow path 132, and the connecting flow path 133 are aligned along the inverter outer peripheral surface 910. The first flow path 131 and the second flow path 132 are aligned in the axial direction AD. The first flow path 131 is positioned on an outer peripheral upstream end 910a side of the second flow path 132. The connecting flow path 133 is provided at a position between the first flow path 131 and the second flow path 132 in the axial direction AD. The connecting flow path 133 connects the first flow path 131 and the second flow path 132.

The first flow path 131 is a space between two first fins 921 adjacent to each other in the circumferential direction CD. The first flow path 131 is formed by two first fin surfaces 111 that face each other in the circumferential direction CD. The first flow path 131 extends in the axial direction AD along the inverter outer peripheral surface 910 and the first fin surface 111.

The first flow path 131 is open toward the upstream side, downstream side, and outer periphery side. The first flow path 131 includes a first upstream port 131a and a first downstream port 131b. The first upstream port 131a opens the first flow path 131 toward an upstream side. The first upstream port 131a is positioned to be aligned with the first upstream end 112 in the circumferential direction CD. The first downstream port 131b opens the first flow path 131 toward a downstream side. The first downstream port 131b is positioned to be aligned with the first downstream end 113 in the circumferential direction CD. The first upstream port 131a and the first downstream port 131b are aligned in the axial direction AD.

In the circumferential direction CD, a width dimension of the first flow path 131 is the same as the first distance D1. The width dimension of the first flow path 131 is greatest at the first upstream port 131a. The width dimension of the first upstream port 131a is the same as the distance D1a. The width dimension of the first flow path 131 is smallest at the first downstream port 131b. The width dimension of the first downstream port 131b is the same as the distance D1b.

The cross-sectional area of the first flow path 131 gradually decreases from the first upstream port 131a toward the first downstream port 131b. The cross-sectional area of the first flow path 131 is an area of the first flow path 131 on a plane obtained by cutting the first flow path 131 in a direction perpendicular to the axial direction AD. In the first flow path 131, a first upstream port area S131a is the largest. The first upstream port area S131a is an opening area of the first upstream port 131a. The first upstream port area S131a may also be referred to as a cross-sectional area of the first upstream port 131a. In the first flow path 131, a first downstream port area S131b is the smallest. The first downstream port area S131b is an opening area of the first downstream port 131b. The first downstream port area S131b may also be referred to as a cross-sectional area of the first downstream port 131b.

The second flow path 132 is a space between two second fins 922 adjacent to each other in the circumferential direction CD. The second flow path 132 is formed by two second fin surfaces 121 that face each other in the circumferential direction CD. The second flow path 132 extends in the axial direction AD along the inverter outer peripheral surface 910 and the second fin surface 121.

The second flow path 132 is open toward the upstream side, downstream side, and outer periphery side. The second flow path 132 includes a second upstream port 132a and a second downstream port 132b. The second upstream port 132a opens the second flow path 132 toward an upstream side. The second upstream port 132a is positioned to be aligned with the second upstream end 122 in the circumferential direction CD. The second downstream port 132b opens the second flow path 132 toward a downstream side. The second downstream port 132b is positioned to be aligned with the second downstream end 123 in the circumferential direction CD. The second upstream port 132a and the second downstream port 132b are aligned in the axial direction AD.

In the circumferential direction CD, a width dimension of the second flow path 132 is the same as the second distance D2. The width dimension of the second flow path 132 is smallest at the second upstream port 132a. The width dimension of the second upstream port 132a is the same as the distance D2a. The width dimension of the second flow path 132 is greatest at the second downstream port 132b. The width dimension of the second downstream port 132b is the same as the distance D2b.

The cross-sectional area of the second flow path 132 gradually increases from the second upstream port 132a toward the second downstream port 132b. The cross-sectional area of the second flow path 132 is an area of the second flow path 132 on a plane obtained by cutting the second flow path 132 in a direction perpendicular to the axial direction AD. In the second flow path 132, the second upstream port area S132a is the smallest. The second upstream port area S132a is an opening area of the second upstream port 132a. The second upstream port area S132a may also be referred to as a cross-sectional area of the second upstream port 132a. In the second flow path 132, the second downstream port area S132b is the largest. The second downstream port area S132b is an opening area of the second downstream port 132b. The second downstream port area S132b may also be referred to as a cross-sectional area of the second downstream port 132b.

Regarding the first flow path 131 and the second flow path 132, the first downstream port 131b and the second upstream port 132a are aligned in the axial direction AD. The first downstream port 131b opens in the axial direction AD toward the outer peripheral downstream end 910b. The first downstream port 131b corresponds to a first opposing port. The second upstream port 132a opens in the axial direction AD toward the outer peripheral upstream end 910a. The second upstream port 132a corresponds to a second opposing port. The first downstream port 131b and the second upstream port 132a are not shifted from each other in the circumferential direction CD. For example, one of the first downstream port 131b and the second upstream port 132a does not protrude from the other in the circumferential direction CD. Further, the width dimension of the first downstream port 131b is the same as the width dimension of the second upstream port 132a. Note that the first downstream port area S131b and the second upstream port area S132a are the same.

The first upstream port 131a and the second downstream port 132b are aligned in the axial direction AD. The first upstream port 131a and the second downstream port 132b are not shifted from each other in the circumferential direction CD. For example, one of the first upstream port 131a and the second downstream port 132b does not protrude beyond the other in the circumferential direction CD. The width of the first upstream port 131a is the same as the width of the second downstream port 132b. The first upstream port area S131a and the second downstream port area S132b are the same.

The connecting flow paths 133 connect the plurality of first flow paths 131 and the plurality of second flow paths 132. The connecting flow path 133 extends in the circumferential direction CD to bridge the plurality of first flow paths 131. The connecting flow path 133 connects two first flow paths 131 adjacent to each other in the circumferential direction CD. The first downstream port 131b is included in a boundary between the connecting flow path 133 and the first flow path 131. The connecting flow path 133 extends in the circumferential direction CD to bridge the plurality of the second flow paths 132. The connecting flow path 133 connects two second flow paths 132 adjacent to each other in the circumferential direction CD. The second upstream port 132a is included in a boundary between the connecting flow path 133 and the second flow path 132.

The connecting flow path 133 is open toward the upstream side, downstream side, and outer periphery side. The connecting flow path 133 includes a space between the first fin 921 and the second fin 922. This space is formed by the first downstream end 113 and the second upstream end 122. The connecting flow path 133 includes a space that connects the first flow path 131 and the second flow path 132. In the axial direction AD, the width dimension of the connecting flow path 133 is the same as the third distance D3. The width dimension of the connecting flow path 133 is greater than the width dimension of the first downstream port 131b and the width dimension of the second upstream port 132a. The width dimension of the connecting flow path 133 is smaller than the width dimension of the first upstream port 131a and the width dimension of the second downstream port 132b.

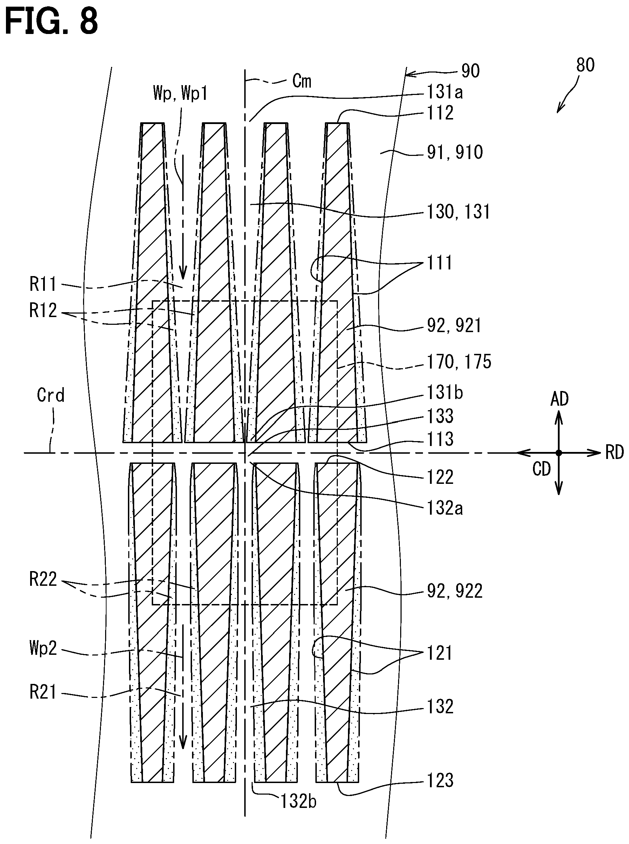

As shown in FIG. 8, when the propeller wind Wp flows into the fin flow path 130, main flow regions R11, R21 and thermal boundary layers R12, R22 may be formed in the fin flow path 130. When temperature of the inverter housing 90 rises due to heat generated in the inverter unit 170 or the like, a temperature difference is likely to occur between the propeller wind Wp flowing into the fin flow path 130 and the inverter fins 92. The main flow regions R11 and R21 are regions through which the propeller wind Wp, which has a temperature difference with the inverter fins 92, easily flows. The thermal boundary layers R12 and R22 are regions where the temperature of the propeller wind Wp is likely to change due to heat from the inverter fins 92. The thermal boundary layers R12 and R22 are formed to extend in layers along the outer surfaces of the inverter fins 92. The thermal boundary layers R12 and R22 may also be referred to as thermal boundary regions. The main flow regions R11 and R21 may also be referred to as main flow temperature regions.

The propeller wind Wp includes a first propeller wind Wp1. The first propeller wind Wp1 is a propeller wind Wp that flows through the first flow path 131. The first propeller wind Wp1 flows into the first flow path 131 from the first upstream port 131a. The first propeller wind Wp1 flows through the first flow path 131 in the axial direction AD.

In the first flow path 131, the first propeller wind Wp1 flows, and a first main flow region R11 and a first thermal boundary layer R12 may be formed. The first thermal boundary layer R12 is formed to extend in a layer in the axial direction AD along the first fin surface 111. For example, the thickness of the first thermal boundary layer R12 gradually increases in the circumferential direction CD from the first upstream port 131a toward the first downstream port 131b. The first main flow region R11 is positioned on an opposite side of the first fin 921 in the circumferential direction CD across the first thermal boundary layer R12. The first main flow region R11 is formed at a position between two first thermal boundary layers R12 adjacent to each other in the circumferential direction CD. For example, in the first main flow region R11, the width in the circumferential direction CD gradually decreases from the first upstream port 131a toward the first downstream port 131b.

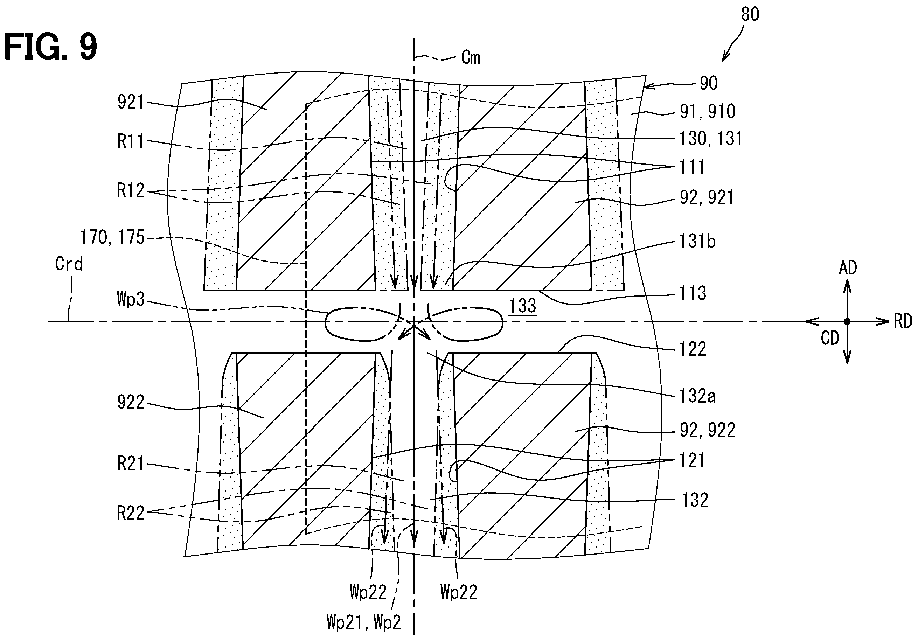

As shown in FIG. 9, the first propeller wind Wp1 includes a first main wind Wp11 and a first boundary wind Wp12. The first main wind Wp11 flows in the axial direction AD through the first main flow region R11 toward the first downstream port 131b. The first boundary wind Wp12 flows in the axial direction AD through the first thermal boundary layer R12 toward the first downstream port 131b. The temperature of the first boundary wind Wp12 is likely to rise in the first thermal boundary layer R12. The temperature of the first boundary wind Wp12 tends to be higher than the temperature of the first main wind Wp11. That is, a temperature difference is likely to occur between the first boundary wind Wp12 and the first main wind Wp11.

As shown in FIG. 8, the propeller wind Wp includes a second propeller wind Wp2. The second propeller wind Wp2 is the propeller wind Wp that flows through the second flow path 132. The second propeller wind Wp2 flows into the second flow path 132 from the second upstream port 132a. The second propeller wind Wp2 flows through the second flow path 132 in the axial direction AD.

In the second flow path 132, the flow of the second propeller wind Wp2 may form a second main flow region R21 and a second thermal boundary layer R22. The second thermal boundary layer R22 is formed to extend in a layer in the axial direction AD along the second fin surface 121. For example, the thickness of the second thermal boundary layer R22 gradually increases in the circumferential direction CD from the second upstream port 132a toward the second downstream port 132b. The second main flow region R21 is positioned on an opposite side of the second fin 922 in the circumferential direction CD across the second thermal boundary layer R22. The second main flow region R21 is a space between two second thermal boundary layers R22 adjacent to each other in the circumferential direction CD.

As shown in FIG. 9, the second propeller wind Wp2 includes a second main wind Wp21 and a second boundary wind Wp22. The second main wind Wp21 flows in the axial direction AD through the second main flow region R21 toward the second downstream port 132b. The second boundary wind Wp22 flows in the axial direction AD through the second thermal boundary layer R22 toward the second downstream port 132b. The second boundary wind Wp22 is likely to experience a temperature increase in the second thermal boundary layer R22. The temperature of the second boundary wind Wp22 tends to be higher than the temperature of the second main wind Wp21. That is, a temperature difference is likely to occur between the second boundary wind Wp22 and the second main wind Wp21.

For example, consider a comparative example 1 in which the first boundary wind Wp12 flowing through the first thermal boundary layer R12 continues to flow in the axial direction AD and flows through the second thermal boundary layer R22 as the second boundary wind Wp22 because no disturbances such as vortices occur in the propeller wind Wp in the fin flow path 130. In the comparative example 1, the first boundary wind Wp12 becomes the second boundary wind Wp22, temperature of which further rises in the second thermal boundary layer R22. Therefore, the temperature difference between the second boundary wind Wp22 and the second main wind Wp21 is likely to be greater than the temperature difference between the first boundary wind Wp12 and the first main wind Wp11. In such case, the second thermal boundary layer R22 tends to become thicker in the circumferential direction CD. Further, in such case, the second main flow region R21 tends to become narrower in the circumferential direction CD. Therefore, in the second flow path 132, there is a concern that the high temperature of the second boundary wind Wp22 will reduce the heat dissipation effect of the second fins 922 due to the second boundary wind Wp22.

In contrast to the above, in the present embodiment, the connecting flow path 133 is provided at a position between the first flow path 131 and the second flow path 132, which makes it easier for turbulence to occur in the propeller wind Wp. For example, when the first propeller wind Wp1 flows into the connecting flow path 133 from the first downstream port 131b, the first propeller wind Wp1 is likely to become turbulent due to separation from the first downstream end 113, for example. In such case, the first main wind Wp11 and the first boundary wind Wp12 flow into the connecting flow path 133 as the first propeller wind Wp1. The first main wind Wp11 and the first boundary wind Wp12 are likely to be stirred due to turbulence that occurs when they flow into the connecting flow path 133.

Regarding the connecting flow path 133, the width dimension of the first downstream port 131b, the width dimension of the second upstream port 132a, the width dimension of the connecting flow path 133, and the like are set to values that make it easy to stir the first propeller wind Wp1 that flows into the connecting flow path 133. For example, when the width dimension of the connecting flow path 133 is too small, the first propeller wind Wp1 that has flowed into the connecting flow path 133 may be not easily stirred. That is, the amount of stir of the first propeller wind Wp1 may be insufficient. When the width dimension of the connecting flow path 133 is appropriately large, the first propeller wind Wp1 that flows into the connecting flow path 133 is easily stirred. That is, the amount of stir of the first propeller wind Wp1 is unlikely to become insufficient. In addition, the width dimension W1b of the first downstream end 113, the width dimension W2a of the second upstream end 122, the shape and size of the first fin 921, and the shape and size of the second fin 922 are also set to make it easier to stir the first propeller wind Wp1 that flows into the connecting flow path 133.

The propeller wind Wp includes a third propeller wind Wp3. The third propeller wind Wp3 is a propeller wind Wp that flows through the connecting flow path 133. The third propeller wind Wp3 includes the first propeller wind Wp1 that flows from the first flow path 131 into the connecting flow path 133. That is, the third propeller wind Wp3 includes the first main wind Wp11 and the first boundary wind Wp12. The third propeller wind Wp3 tends to stir the first main wind Wp11 and the first boundary wind Wp12. Therefore, in the connecting flow path 133, the temperature of the third propeller wind Wp3 tends to be made even.

The third propeller wind Wp3 flows from the connecting flow path 133 into the second flow path 132, and thereby flows through the second flow path 132 as the second propeller wind Wp2. The third propeller wind Wp3 flowing into the second main flow region R21 flows through the second main flow region R21 as the second main wind Wp21. The third propeller wind Wp3 flowing into the second thermal boundary layer R22 flows through the second thermal boundary layer R22 as the second boundary wind Wp22. As described above, since the temperature of the third propeller wind Wp3 has been made even, the temperature of the second main wind Wp21 flowing into the second main flow region R21 and the temperature of the second boundary wind Wp22 flowing into the second thermal boundary layer R22 are approximately the same.

Therefore, in the present embodiment, the temperature of the second boundary wind Wp22 is more likely to be lower than the one in the comparative example 1. In such case, compared to the above-described comparative example 1, the second thermal boundary layer R22 is more likely to become thin in the circumferential direction CD. Further, in such case, the second main flow region R21 is likely to be thicker in the circumferential direction CD than in the comparative example 1. Therefore, compared to the comparative example 1, the heat dissipation effect of the second fins 922 due to the second boundary wind Wp22 is improved.

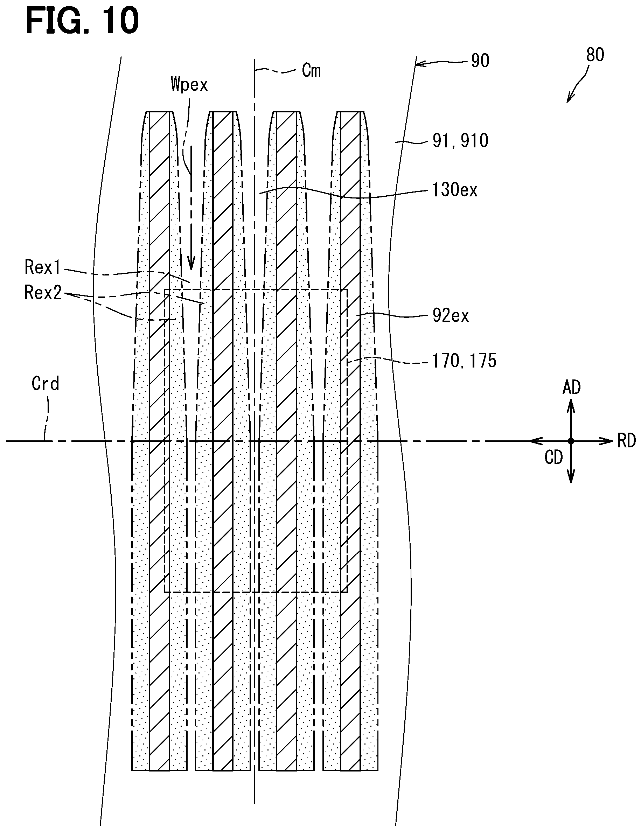

Next, a comparative example 2 will be considered in which the fin flow path 130 does not have the second flow path 132 and the connecting flow path 133. In the comparative example 2, as shown in FIG. 10, comparative fins 921ex are provided on the inverter outer peripheral surface 910 as the inverter fins 92. The comparative fin 921ex extends across the inverter unit 170 in the axial direction AD. In the comparative example 2, a comparative flow path 130ex is formed by two comparative fins 921ex adjacent to each other in the circumferential direction CD. The comparative flow path 130ex does not include a flow path corresponding to the connecting flow path 133.

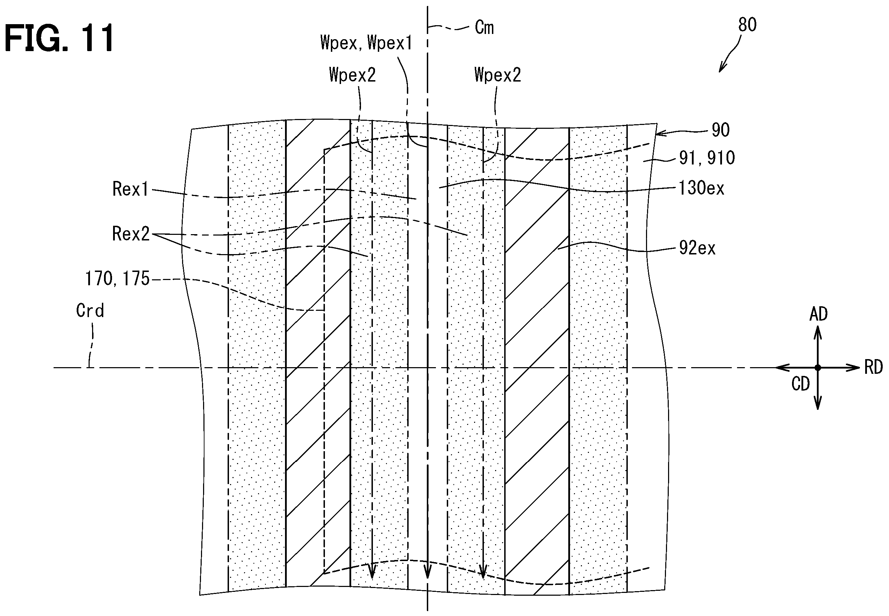

In the comparative flow path 130ex, the comparative wind Wpex flows in the axial direction AD along the comparative fin 921ex. In the comparative flow path 130ex, the comparative wind Wpex flows, thereby forming a comparative main flow region Rex1 and a comparative thermal boundary layer Rex2. As shown in FIG. 11, the comparative wind Wpex includes a comparative main wind Wpex1 and a comparative boundary wind Wpex2. The comparative main wind Wpex1 flows through the comparative main flow region Rex1. The comparative boundary wind Wpex2 flows through the comparative thermal boundary layer Rex2.

In the comparative flow path 130ex, the comparative main wind Wpex1 and the comparative boundary wind Wpex2 are not easily stirred until the comparative wind Wpex that has flowed in from the upstream side flows out to the downstream side. Therefore, in the comparative flow path 130ex, the temperature difference between the comparative main wind Wpex1 and the comparative boundary wind Wpex2 tends to increase as the comparative wind Wpex flows toward downstream. Therefore, in the comparative example 2, there is a concern that the heat dissipation effect of the comparative fins 921ex by the comparative wind Wpex will be insufficient further downstream in the comparative flow path 130ex. There is also a concern that the comparative wind Wpex may be not effective in dissipating heat from the inverter unit 170.

Description of the inverter fins 92 of the present embodiment is summarized. There is a very high demand for weight reduction for the eVTOL10, an electric vertical take-off and landing flight vehicle. Therefore, the weight of the EPU 50 is reduced by reducing the size of the inverter housing 90 and other enclosures, and by reducing the number of parallel-connected semiconductor elements such as the arm switch 86 and the like. In order to reduce the weight of the EPU 50, it is preferable to apply a cooling structure with low airflow pressure loss and high cooling performance to the air-cooled housing.

Further, the EPU 50, which is an electric propulsion unit, is a product made up of the motor 61 that drives the propeller 20 and the inverter unit 170 that drives the motor 61. The motor 61 and the inverter unit 170 generate heat and loss when they are driven, and therefore need to be cooled. In the eVTOL 10, in order to reduce the weight of the EPU 50, the EPU 50 is generally cooled by air cooling. Specifically, the airflow generated by the propeller 20 or the airflow generated by a fan separate from the propeller 20 passes between the heat dissipation fins installed on the outer surface of the housing of the EPU 50, thereby dissipating heat from the EPU 50.

In the inverter device 80 mounted on the eVTOL 10, heat-generating components such as the switch component 175 may be arranged in one position in a main airflow direction such as the propeller wind Wp. Further, the inverter device 80 may have low thermal dissipation character due to factors such as the thin thickness of the housing. In response to these issues, it was discovered that the performance of the EPU 50 is more likely to be improved by improving the local cooling performance of the housing rather than by increasing the surface area of heat dissipation fins such as the inverter fins 92 to improve the heat dissipation performance of the housing.

In contrast to the above, in the present embodiment, the inverter fins 92 are provided on the inverter housing 90 in a state in which they are divided into a plurality of parts in the axial direction AD. That is, the inverter fins 92 are configured in a divided manner, i.e., being divided into the first fin 921 and the second fin 922. In such configuration, the airflow is disturbed in the space between the first fin 921 and the second fin 922, making it easier for the higher temperature airflow flowing near the first fin 921 to mix with the lower temperature airflow flowing away from the first fin 921. In such manner, it is easier for the temperature of the airflow flowing near the second fins 922 to lower. That is, the second thermal boundary layer R22 formed along the second fin 922 tends to become thin. Therefore, the cooling performance of the second fins 922 is improved.

Further, in such configuration, since the first fin 921 and the second fin 922 are divided, the space between the first fin 921 and the second fin 922 can be made into a non-installation area where no heat dissipation fins are installed. Therefore, the mass of the inverter fins 92 is reduced by the amount of the non-installation area, and the weight of the EPU 50 is reducible.

Further, the first fin 921 is formed in a tapered shape so that the area of the first flow path 131 decreases toward the heating element such as the inverter unit 170. According to such configuration, the first propeller wind Wp1 flows faster in the first flow path 131 as it flows toward the first downstream port 131b. That is, in the first flow path 131, the flow speed of the first propeller wind Wp1 is more likely to increase at a position closer to the inverter unit 170. When the flow speed of the first propeller wind Wp1 increases in such manner, a heat transfer coefficient for the first flow path 131 tends to increase. Therefore, the heat dissipation performance of the inverter housing 90 due to the first propeller wind Wp1 is improvable. Further, the heat transfer coefficient of the first flow path 131 is increased, thereby improving the thermal conductance.

Further, in such configuration, the first main wind Wp11 and the first boundary wind Wp12 are easily mixed in the connecting flow path 133 due to the fast flow speed of the first propeller wind Wp1 flowing from the first flow path 131 into the connecting flow path 133. In such manner, as the first flow path 131 becomes narrower as it approaches the connecting flow path 133, a configuration in which the third propeller wind Wp3 is easily stirred in the connecting flow path 133 is realized.

Further, in such configuration, the flow speed of the first propeller wind Wp1 tends to increase in the first flow path 131 at a position closer to the inverter unit 170. Therefore, the heat transfer coefficient of the first propeller wind Wp1 increases, and heat from the inverter unit 170 is more likely to be dissipated from the inverter outer peripheral wall 95 and the first fins 921 to the first propeller wind Wp1. Therefore, the heat dissipation performance of the heat generating portion is improvable by the first propeller wind Wp1.

According to the present embodiment described so far, the first fin 921 and the second fin 922 are provided at positions spaced apart in a direction perpendicular to the axial direction AD. In such configuration, at positions aligned with the inverter unit 170 in the radial direction RD, turbulence such as vortices is likely to occur in the propeller wind Wp flowing through the space between the first fin 921 and the second fin 922. Therefore, heat from the inverter unit 170 is more likely to be dissipated to the outside of the inverter housing 90 via the first fins 921, the second fins 922 and the inverter outer peripheral wall 95. That is, by utilizing the turbulence of the propeller wind Wp, the heat dissipation effect of the first fins 921, the second fins 922, and the inverter outer peripheral surface 910 is improvable. In such manner, by locally generating turbulence in the propeller wind Wp at a position outside the inverter housing 90 aligned with the inverter unit 170 in the radial direction RD, it is possible to prevent an increase in pressure loss throughout the fin flow path 130. Therefore, it is possible to prevent the amount of propeller wind Wp flowing through the fin flow path 130 from becoming insufficient, and to enhance the heat dissipation effect of the inverter unit 170 by the propeller wind Wp. As described above, the heat dissipation effect of the inverter housing 90 in the EPU 50 is improvable by the inverter fins 92.

According to the present embodiment, the first distance D1 between two first fins 921 adjacent to each other in the circumferential direction CD gradually decreases toward the outer peripheral downstream end 910b. In such configuration, the width dimension of the first flow path 131 becomes smaller as it approaches the inverter unit 170. Therefore, in the first flow path 131, the flow speed of the first propeller wind Wp1 tends to become faster at a position closer to the inverter unit 170. Therefore, the cooling effect of the first propeller wind Wp1 can be locally increased at a position overlapping the inverter unit 170 in the axial direction AD.

According to the present embodiment, the width dimension W1 of the first fin 921 in the circumferential direction CD gradually increases toward the outer peripheral downstream end 910b. That is, the first fin 921 is an expanded fin. Therefore, a configuration in which the width dimension of the first flow path 131 becomes smaller at a position closer to the outer peripheral downstream end 910b is realized. That is, a configuration in which the cooling effect of the first propeller wind Wp1 is locally increased at the installation position of the inverter unit 170 is realized.

According to the present embodiment, in the fin flow path 130, the first downstream port 131b and the second upstream port 132a are aligned in the axial direction AD. In such configuration, the propeller wind Wp that flows into the connecting flow path 133 from the first downstream port 131b is likely to cause turbulence, while the propeller wind Wp that flows into the connecting flow path 133 from the first downstream port 131b is likely to flow out from the second upstream port 132a. Therefore, in the connecting flow path 133, the turbulence of the propeller wind Wp improves the cooling effect of the inverter unit 170, while the presence of the connecting flow path 133 can prevent excessive increase in pressure loss in the fin flow path 130. Therefore, the heat dissipation effect of the inverter housing 90 is improvable by both of the turbulence generated in the propeller wind Wp and the increased flow speed of the propeller wind Wp.

According to the present embodiment, the switch component 175 is provided on the inverter inner peripheral surface 913. Further, the first fin 921 and the second fin 922 extend in the axial direction AD from positions aligned with the switch component 175 in the radial direction RD. In such configuration, the connecting flow path 133, which is a space between the first fin 921 and the second fin 922, is provided at a position aligned with the switch component 175 in the radial direction RD. Therefore, in the connecting flow path 133, the effect of improving the cooling performance due to the localized turbulence of the propeller wind Wp can be provided to the switch component 175.

According to the present embodiment, the inverter housing 90 houses the inverter unit 170 as a heat generating portion. In such configuration, the inverter fins 92 can prevent the temperature of the inverter device 80 from rising excessively due to heat generated in the inverter unit 170.

According to the present embodiment, the EPU 50 drives the eVTOL 10 to fly. In such configuration, when the eVTOL 10 is flying by the drive of the EPU 50, the inverter fins 92 can prevent the temperature of the EPU 50 from rising excessively due to insufficient heat dissipation effect of the inverter housing 90. Therefore, the inverter fins 92 can improve the safety of the eVTOL 10.

### <Second Embodiment>

In the first embodiment, the width dimension W1b of the first downstream end 113 and the width dimension W2a of the second upstream end 122 are the same. In contrast, in the second embodiment, the width dimension W2a of the second upstream end 122 is smaller than the width dimension W1b of the first downstream end 113. Configurations, operations, and effects not particularly described in the second embodiment are the same as those in the first embodiment described above. In the second embodiment, differences from the first embodiment will be mainly described.

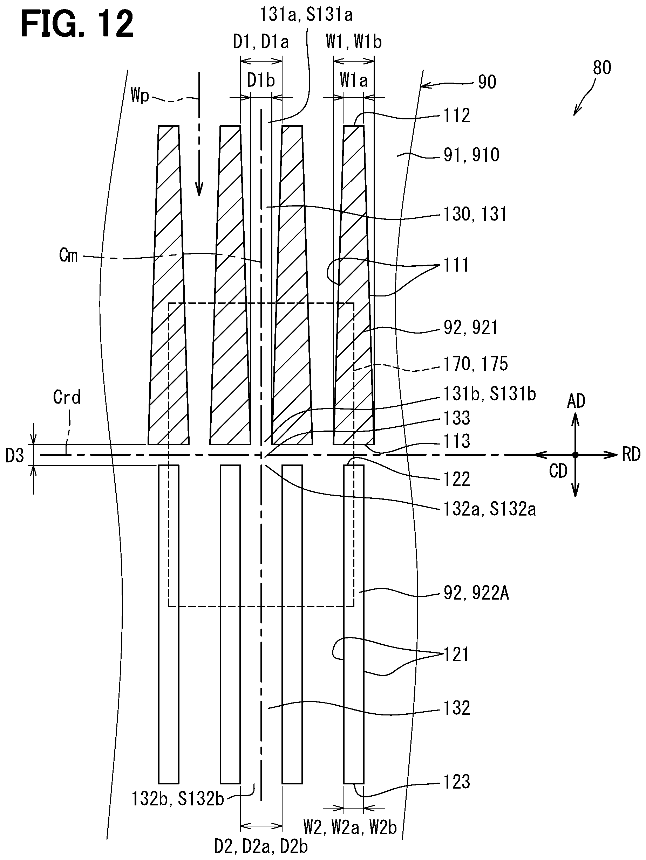

As shown in FIG. 12, in the present embodiment, the second outer peripheral fins are parallel fins. The plurality of inverter fins 92 include second parallel fins 922A as the second outer peripheral fins. The second parallel fins 922A have a different shape from the second fins 922 of the first embodiment. In the second parallel fins 922A, a pair of second fin surfaces 121 extend parallel to the axial direction AD. The pair of second fin surfaces 121 extend parallel to the motor axis Cm. The second parallel fins 922A have a uniform width dimension W2. For example, in the second parallel fin 922A, the width dimension W2a of the second upstream end 122 and the width dimension W2b of the second downstream end 123 are the same. The second parallel fins 922A may also be referred to as parallel fins or straight fins.

The second distance D2 between two second parallel fins 922A adjacent to each other in the circumferential direction CD is uniform. For example, the upstream end distance D2a and the downstream end distance D2b between two second parallel fins 922A adjacent to each other in the circumferential direction CD are the same. In addition, the width dimension of the second flow path 132 is uniform. For example, the width dimension of the second upstream port 132a and the width dimension of the second downstream port 132b are the same. Further, the cross-sectional area of the second flow path 132 is uniform. For example, the second upstream port area S132a and the second downstream port area S132b are the same.

The first downstream end 113 and the second upstream end 122 have different width dimensions in the circumferential direction CD, and are therefore shifted from each other in the circumferential direction CD. For example, the width dimension W1b of the first downstream end 113 and the width dimension W2a of the second upstream end 122 are different. The first downstream end 113 protrudes from the second upstream end 122 to at least one side in the circumferential direction CD. For example, the first downstream end 113 protrudes from the second upstream end 122 on both sides in the circumferential direction CD. The first downstream end 113 protrudes further than the second upstream end 122 to both of one side and the other side in the circumferential direction CD. The first downstream end 113 corresponds to a first opposing end. The second upstream end 122 corresponds to a second opposing end.

The width dimension of the first downstream port 131b and the width dimension of the second upstream port 132a are different. For example, the width dimension of the second upstream port 132a is greater than the width dimension of the first downstream port 131b. The first downstream port area S131b and the second upstream port area S132a are different from each other. For example, the second upstream port area S132a is greater than the first downstream port area S131 b.

Description of the second parallel fins 922A is summarized. In addition to heat dissipation performance, the pressure loss of the refrigerant flowing between the heat dissipation fins is also an important performance factor for the EPU 50 mounted on the eVTOL 10. Regarding the above, in the second parallel fin 922A, the second upstream end 122 is thinner than the first downstream end 113 in the circumferential direction CD. By reducing the thickness of the second parallel fins 922A, the cross-sectional area of the second flow path 132 is increased, and thus the pressure loss in the second flow path 132 is improvable. Further, the two second fin surfaces 121 that face each other across the second flow path 132 extend parallel to each other in the axial direction AD, thereby improving pressure loss in the second flow path 132.

Of the two heat dissipation fins lined up in the axial direction AD, the first fin 921, which is the upstream heat dissipation fin, is an expanded fin, so that the flow speed of the propeller wind Wp flowing through the first flow path 131, which is the upstream flow path, can be increased. Further, since the second parallel fin 922A, which is the downstream heat dissipation fin, is thinner than the first fin 921, the propeller wind Wp, whose flow speed has been increased by the first fin 921, can generate a fast flow in a fin division section due to its inertia. Therefore, mixing of the propeller wind Wp in the fin division section is facilitated. The fin division sections are portions where the inverter fins 92 are divided. For example, the fin division section is a part between an upstream fin such as the first fin 921 and a downstream fin such as the second parallel fin 922A.

The second parallel fins 922A are thinner than the first fins 921, and accordingly the second parallel fins 922A can be made lighter than the first fins 921. In such manner, the weight of the second parallel fins 922A is reduced, and the fin mass is reduced accordingly, which contributes to reducing the weight of the EPU 50 and the inverter housing 90.

According to the present embodiment, the first downstream port 131b and the second upstream port 132a are shifted from each other in the circumferential direction CD. In such configuration, it is unlikely that the propeller wind Wp that flows into the connecting flow path 133 from the first downstream port 131b will flow out from the connecting flow path 133 to the first upstream port 131a in an unstirred state. For example, when the propeller wind Wp flows into the connecting flow path 133 from the first downstream port 131b, the propeller wind Wp is likely to be stirred in the connecting flow path 133 because it is likely to separate from the first downstream end 113, or due to other factors. Therefore, a temperature difference is unlikely to occur in the connecting flow path 133. Thus, it is possible to prevent the heat dissipation effect of the inverter unit 170 by the propeller wind Wp from varying depending on the part of the inverter unit 170.

According to the present embodiment, the width dimension W2a of the second upstream end 122 is smaller than the width dimension W1b of the first downstream end 113. In such manner, a configuration in which the second upstream port area S132a is smaller than the first downstream port area S131b is realized. Thus, it is easier for the propeller wind Wp to flow out from the connecting flow path 133 to the second upstream port 132a. That is, the pressure loss of the propeller wind Wp flowing from the first downstream port 131b through the connecting flow path 133 to the second upstream port 132a is reducible.

### <Third Embodiment>

In the first embodiment, the first flow path 131 and the second flow path 132 are aligned in the axial direction AD. In contrast to the above, in the third embodiment, the first flow path 131 and the second flow path 132 are formed at shifted positions in the circumferential direction CD. Configurations, operations, and effects not particularly described in the third embodiment are the same as those in the first embodiment. In the third embodiment, differences from the first embodiment will be mainly described.

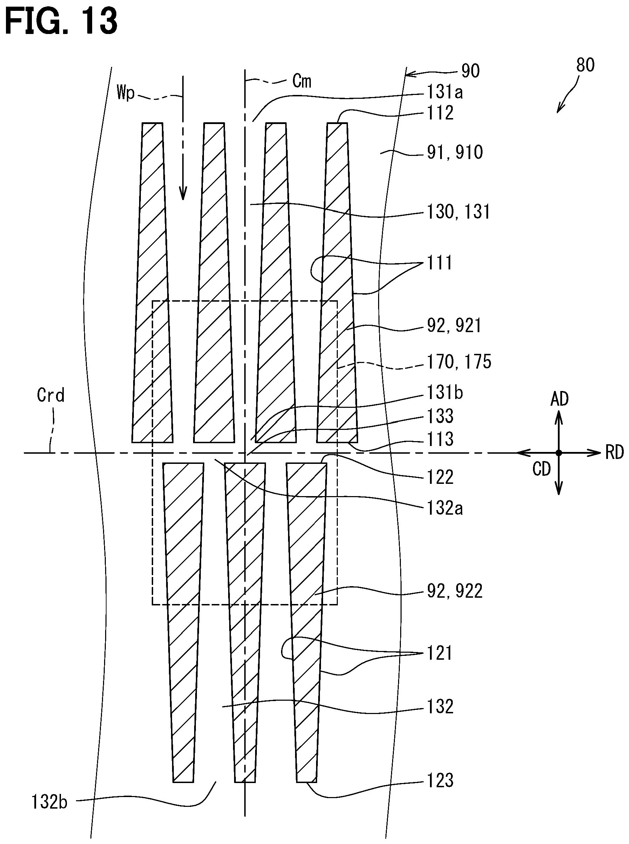

As shown in FIG. 13, the positions of the first fin 921 and the second fin 922 are shifted from each other in the circumferential direction CD. That is, the first fin 921 and the second fin 922 are offset in the circumferential direction CD. The first fin 921 and the second flow path 132 are aligned in the axial direction AD. The second fin 922 and the first flow path 131 are aligned in the axial direction AD. The first flow path 131 and the second flow path 132 are spaced apart from each other in the circumferential direction CD. The first downstream port 131b and the second upstream port 132a are positioned apart from each other in the circumferential direction CD. Note that a part of the first downstream port 131b and a part of the second upstream port 132a may be aligned in the axial direction AD.

The first downstream end 113 and the second upstream end 122 are shifted from each other to different positions in the circumferential direction CD, and are therefore shifted in the circumferential direction CD. For example, a part of the first downstream end 113 and a part of the second upstream end 122 are aligned in the axial direction AD. The first downstream end 113 is in a state of bridging two second upstream ends 122 adjacent to each other in the circumferential direction CD. The first downstream end 113 is provided at a position aligned with the second upstream port 132a in the axial direction AD. The second upstream end 122 is in a state of bridging two first downstream ends 113 adjacent to each other in the circumferential direction CD. The second upstream end 122 is provided at a position aligned with the first downstream port 131b in the axial direction AD.

According to the present embodiment, the second upstream end 122 is provided at a position aligned with the first downstream port 131b in the axial direction AD. In such configuration, the propeller wind Wp that flows into the connecting flow path 133 from the first downstream port 131b advances toward the second upstream end 122. Such a propeller wind Wp approaches or collides with the second upstream end 122, thereby facilitating the mixing and stirring of the propeller wind Wp in the connecting flow path 133. Therefore, the temperature of the propeller wind Wp in the connecting flow path 133 can be made uniform.

In the present embodiment, the width dimension of the connecting flow path 133 may be smaller than the width dimension of the first downstream port 131b and the width dimension of the second upstream port 132a. That is, the cross-sectional area of the connecting flow path 133 may be smaller than the first downstream port area S131b and the second upstream port area S132a. In such configuration, the connecting flow path 133 narrows the fin flow path 130 more than the first downstream port 131b and the second upstream port 132a. Therefore, in a configuration in which the first downstream end 113 and the second upstream end 122 are offset in the circumferential direction CD, the flow speed of the propeller wind Wp that flows into the connecting flow path 133 from the first downstream port 131b is likely to increase as it flows through the connecting flow path 133 in the circumferential direction CD. Therefore, the flow speed of the propeller wind Wp increases at the position aligned with the inverter unit 170 in the radial direction RD, thereby improving the heat dissipation performance of the inverter unit 170 by the propeller wind Wp.

### <Fourth Embodiment>

In the fourth embodiment, the inverter housing 90 is covered by a duct member on the outer periphery side. Configurations, operations, and effects not particularly described in the fourth embodiment are the same as those of the third embodiment. In the fourth embodiment, differences from the third embodiment will be mainly described.

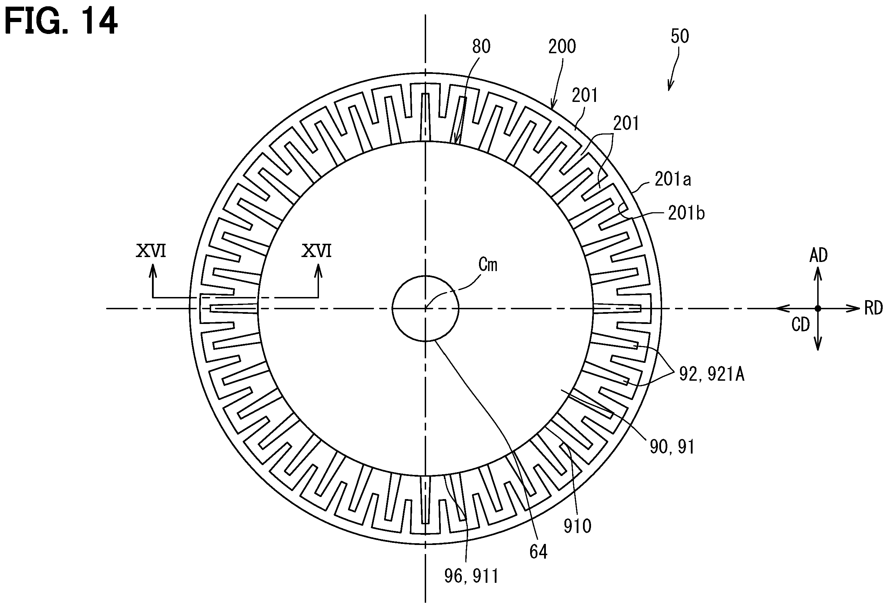

As shown in FIG. 14, the EPU 50 includes an outer circumferential duct 200. The outer circumferential duct 200 covers the inverter housing 90 from the outer periphery side. The outer circumferential duct 200 may also be referred to as a duct member or an outer cylinder. The outer circumferential duct 200 includes a duct body 201 and duct fins 202. The duct body 201 and the duct fins 202 are formed from a resin material or the like. The duct body 201 and the duct fins 202 have thermal conductivity. The duct body 201 and the duct fins 202 may be made of a metal material.

The duct body 201 is formed in a cylindrical shape, and extends in the axial direction AD. The duct body 201 extends in the circumferential direction CD to support the plurality of inverter fins 92 in a bridging manner. The duct body 201 is provided o a radially outer side of the inverter outer peripheral surface 910 via the inverter fins 92. The duct body 201 covers the inverter outer peripheral surface 910 from the radially outer side. The duct body 201 is provided at a position close to or in contact with the inverter fins 92 in the radial direction RD. The fin flow path 130 is formed at a position between the inverter outer peripheral surface 910 and the duct body 201. The duct body 201 forms the fin flow path 130 between itself and the inverter outer peripheral surface 910. The duct body 201 corresponds to a duct part, and the fin flow path 130 corresponds to an outer circumferential flow path.

The duct body 201 includes a duct outer peripheral surface 201a and a duct inner peripheral surface 201b. The duct outer peripheral surface 201a and the duct inner peripheral surface 201b are formed in an annular shape and extend in the axial direction AD. The duct outer peripheral surface 201a is an outer peripheral surface of the duct body 201. The duct inner peripheral surface 201b is an inner peripheral surface of the duct body 201. The duct inner peripheral surface 201b faces the inverter outer peripheral surface 910 via the inverter fins 92. The fin flow path 130 is formed by the duct inner peripheral surface 201b and the inverter outer peripheral surface 910.

The duct fins 202 are provided on the duct inner peripheral surface 201b. The duct fin 202 is formed in a plate shape, and extends in a direction perpendicular to the circumferential direction CD. The duct fins 202 extend from the duct inner peripheral surface 201b toward the inverter outer peripheral surface 910. The duct fins 202 are convex portions that protrude inward from the duct inner peripheral surface 201b. The duct fins 202 extend in the axial direction AD along the duct inner peripheral surface 201b. A plurality of duct fins 202 are arranged in the circumferential direction CD along the duct inner peripheral surface 201b.

At least a part of the duct fin 202 is provided at a position between two inverter fins 92 adjacent to each other in the circumferential direction CD. The duct fin 202 is inserted from the radially outer side into a position between two inverter fins 92 adjacent to each other in the circumferential direction CD. That is, the duct fins 202 are inserted into the fin flow paths 130 from the radially outer side. The duct fins 202 and the inverter fins 92 are arranged alternately in the circumferential direction CD.

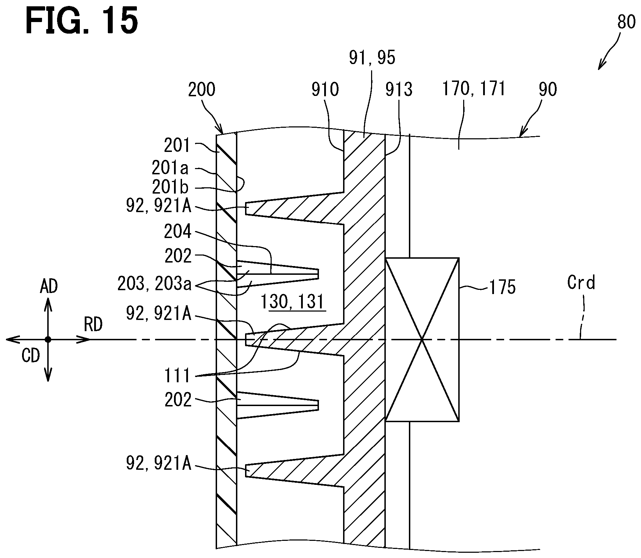

As shown in FIGs. 15 to 17, the duct fin 202 includes a pair of duct fin surfaces 203. The duct fin surface 203 is a plate surface of the duct fin 202. The duct fin surfaces 203 extend in a direction perpendicular to the circumferential direction CD, and a pair of duct fin surfaces 203 are aligned in the circumferential direction CD. The duct fin surface 203 is also a side surface of the duct fin 202, and may also be referred to as a fin side surface. The duct fin surface 203 includes an upstream fin surface 203a and a downstream fin surface 203b. The upstream fin surface 203a and the downstream fin surface 203b are aligned in the axial direction AD. For example, the upstream fin surface 203a extends upstream from the downstream fin surface 203b.

The duct fin 202 includes a fin upstream end 204 and a fin downstream end 205 as a pair of ends aligned in the axial direction AD. The fin upstream end 204 is an upstream end of the duct fin 202. The fin downstream end 205 is a downstream end of the duct fin 202.

The duct fin 202 has a shape in which a middle portion in the axial direction AD bulges in the circumferential direction CD. In the circumferential direction CD, the width dimension of the duct fin 202 gradually decreases from the middle portion toward each of the fin upstream end 204 and the fin downstream end 205.

At least one of the upstream fin surface 203a and the downstream fin surface 203b is inclined in the circumferential direction CD with respect to the motor axis Cm. For example, the upstream fin surface 203a is inclined to one side in the circumferential direction CD with respect to the motor axis Cm. The downstream fin surface 203b is inclined toward the other side in the circumferential direction CD with respect to the motor axis Cm. The upstream fin surface 203a and the downstream fin surface 203b extend straight in the axial direction AD. The upstream fin surface 203a and the downstream fin surface 203b are tapered surfaces.

As shown in FIG. 15, the duct fin 202 has a shape in which the width in the circumferential direction CD gradually decreases toward the radially inside. The duct fins 202 correspond to tapered fins. The width dimension of the duct fins 202 continuously decreases toward the inverter outer peripheral surface 910. The distance between the pair of duct fin surfaces 203 gradually decreases toward a tip of the duct fin 202. The duct fin surface 203 is inclined in the circumferential direction CD with respect to the outer periphery center line Crd. The duct fin surface 203 extends straight toward the radially inside. The duct fin surface 203 is a tapered surface.

The duct fins 202 may be narrowed in stages toward the radially inside. For example, the duct fin surface 203 may be a stepped surface. Further, the duct fin surface 203 may be curved to be recessed or bulged in the circumferential direction CD. For example, the duct fin surface 203 may be a curved or bent surface.

In the present embodiment, the inverter fins 92 also have a tapered shape, similar to the duct fins 202. The inverter fins 92 have a shape in which the width in the circumferential direction CD gradually decreases toward the radially inside. The first fin surface 111 and the second fin surface 121 are inclined in the circumferential direction CD with respect to the outer periphery center line Crd. An inclination angle of the first fin surface 111 and an inclination angle of the second fin surface 121 relative to the outer periphery center line Crd are the same as the inclination angle of the duct fin surface 203 relative to the outer periphery center line Crd. That is, the duct fin surface 203 extends in the radial direction RD parallel to the first fin surface 111 and the second fin surface 121.

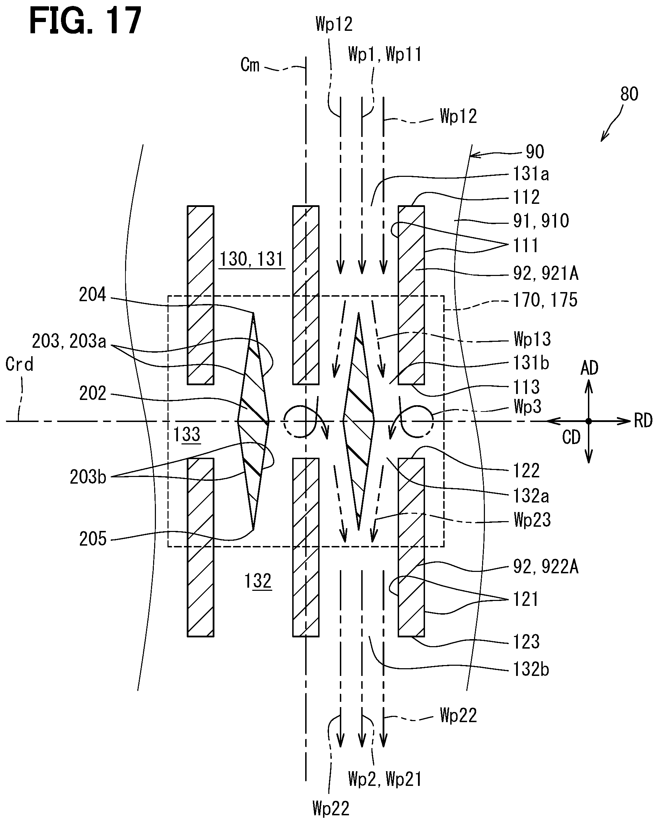

As shown in FIG. 17, the duct fins 202 are provided in the fin flow paths 130. At least a part of the duct fin 202 is provided in the connecting flow path 133 between the first downstream port 131b and the second upstream port 132a. The duct fins 202 extend from the connecting flow path 133 into at least one of the first flow path 131 and the second flow path 132. For example, the duct fin 202 extends in the axial direction AD to bridge the first flow path 131 and the second flow path 132 via the connecting flow path 133. In the duct fin 202, the fin upstream end 204 is provided in the first flow path 131. The fin downstream end 205 is provided in the second flow path 132.

The duct fin 202 is interposed at at least one of (a) a position between two first fins 921 adjacent to each other in the circumferential direction CD and (b) a position between two second fins 922 adjacent to each other in the circumferential direction CD. For example, the duct fin 202 is provided at a position between two first fins 921 adjacent to each other in the circumferential direction CD, and is also provided at a position between two second fins 922 adjacent to each other in the circumferential direction CD. The duct fin 202 corresponds to a fin interposer.

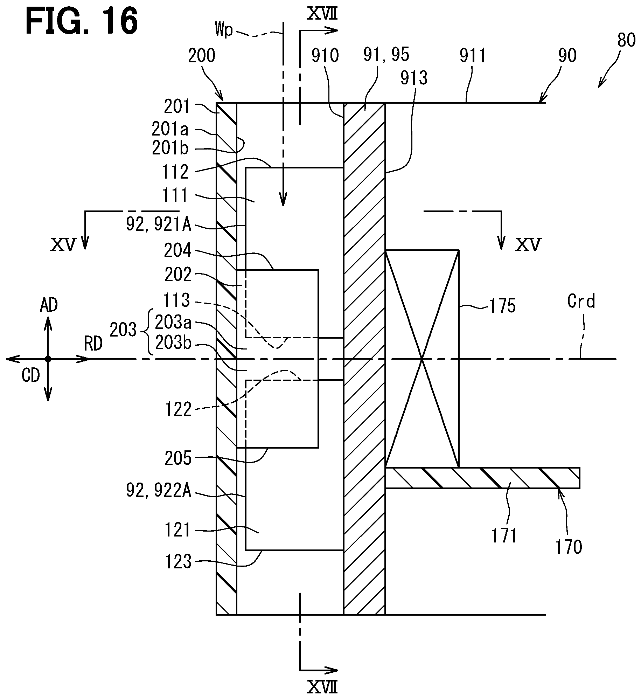

As shown in FIG. 16, at least a part of the duct fin 202 is provided at a position aligned with the inverter unit 170 in the axial direction AD. The duct fin 202 is provided at a position aligned with the switch component 175 in the axial direction AD. For example, the duct fins 202 are provided at positions that do not protrude from the switch component 175 in the axial direction AD. The entire duct fin 202 is aligned with the switch component 175 in the axial direction AD.

As shown in FIG. 17, in the present embodiment, both of the first outer peripheral fins and the second outer peripheral fins are parallel fins. Similar to the second embodiment described above, the plurality of inverter fins 92 include the second parallel fins 922A as the second outer peripheral fins. The plurality of inverter fins 92 include the first parallel fins 921A as the first outer peripheral fins. The first parallel fins 921A have a different shape from the first fins 921 of the first embodiment. In the first parallel fins 921A, a pair of first fin surfaces 111 extend parallel in the axial direction AD. The pair of first fin surfaces 111 extend parallel to the motor axis Cm. The first parallel fins 921A have a uniform width dimension W1. For example, in the first parallel fin 921A, the width dimension W1a of the first upstream end 112 and the width dimension W1b of the first downstream end 113 are the same. The first parallel fins 921A may also be referred to as parallel fins or straight fins.

The first distance D1 between two first parallel fins 921A adjacent to each other in the circumferential direction CD is uniform. For example, the upstream end distance D1a and the downstream end distance D1b between two first parallel fins 921A adjacent to each other in the circumferential direction CD are the same. Further, the width dimension of the first flow path 131 is uniform. For example, the width dimension of the first upstream port 131a and the width dimension of the first downstream port 131b are the same. Further, the cross-sectional area of the first flow path 131 is uniform. For example, the first upstream port area S131a and the first downstream port area S131b are the same.

In the first flow path 131, the distance between the first parallel fin 921A and the duct fin 202 in the circumferential direction CD gradually decreases from the fin upstream end 204 toward the first downstream port 131b in the axial direction AD. Therefore, even in a configuration in which two first fin surfaces 111 adjacent in the circumferential direction CD extend parallel to each other in the axial direction AD, the cross-sectional area of the first flow path 131 gradually decreases toward the first downstream port 131b. The first propeller wind Wp1 tends to have a faster flow speed as it passes between the first parallel fins 921A and the duct fins 202 and approaches the first downstream port 131b.

In the second flow path 132, the distance between the second parallel fin 922A and the duct fin 202 in the circumferential direction CD gradually increases from the second upstream port 132a toward the fin downstream end 205 in the axial direction AD. Therefore, even in a configuration in which two second fin surfaces 121 adjacent in the circumferential direction CD extend parallel to each other in the axial direction AD, the cross-sectional area of the second flow path 132 gradually increases toward the fin downstream end 205.

Description of the outer circumferential duct 200 is summarized. The outer circumferential duct 200 is provided o a radially outer side of the inverter housing 90, and the propeller wind Wp flowing in the axial direction AD as a refrigerant flow is guided by the outer circumferential duct 200. In the inverter device 80, the duct fin 202 is provided at a position between the two heat dissipation fins, so that the flow path area between the two heat dissipation fins is reducible without tapering the heat dissipation fins. Therefore, the duct fins 202 can improve the heat dissipation performance around the fin division sections.

The inverter fins 92 become thinner towards the tips of the fins. That is, the inverter fins 92 become thinner in the circumferential direction CD as they become farther from the inverter outer peripheral surface 910. Therefore, the first distance D1 and the second distance D2 become greater in regions farther outward from the inverter outer peripheral surface 910. In the fin flow path 130, the cross-sectional area of the region far from the inverter outer peripheral surface 910 is greater than the cross-sectional area of the region close to the inverter outer peripheral surface 910.

In contrast, the duct fins 202 become thinner towards the tips of the fins. That is, the duct fins 202 become thinner as they approach the inverter outer peripheral surface 910. Therefore, in the duct fin 202, the cross-sectional area of the part farther from the inverter outer peripheral surface 910 is greater than the cross-sectional area of the part closer to the inverter outer peripheral surface 910. Therefore, in the actual region where the propeller wind Wp actually flows in the fin flow path 130, the presence of the duct fin 202 reduces the cross-sectional area of the region far from the inverter outer peripheral surface 910 to approach the cross-sectional area of the region close to the inverter outer peripheral surface 910. In such manner, a uniform flow is formed in the fin flow path 130 regardless of the height of the heat dissipation fins such as the inverter fins 92.

According to the present embodiment, at least a part of the duct fin 202 is provided at a position between the first downstream port 131b and the second upstream port 132a. In such configuration, when the propeller wind Wp flows into the connecting flow path 133 from the first downstream port 131b, the propeller wind Wp is likely to be stirred by approaching or colliding with the duct fins 202. Therefore, with respect to the propeller wind Wp, the heat dissipation effect on the inverter unit 170 is improvable due to disturbances such as vortices caused by the presence of the duct fins 202.

According to the present embodiment, the duct fins 202 extend in the radial direction RD from the duct body 201 toward the inverter outer peripheral surface 910. In such configuration, by attaching the outer circumferential duct 200 to the inverter housing 90, the duct fins 202 are provided in the fin flow paths 130. Therefore, the duct fins 202 are arrangeable even in positions in the fin flow paths 130 where it is difficult to install the duct fins 202 on the inverter outer peripheral surface 910 due to reasons such as circumstances when manufacturing the inverter housing 90. Therefore, greater freedom of choice is provided regarding the position of the fin interposer such as the duct fin 202.

According to the present embodiment, the width of the duct fin 202 in the circumferential direction CD gradually decreases toward the inverter outer peripheral surface 910. Therefore, even when the width dimension of the fin flow path 130 becomes smaller as it comes closer to the inverter outer peripheral surface 910, the width dimension of the actual area of the fin flow path 130 can be made uniform in the radial direction RD.

### <Other Embodiments>

The disclosure of the present description is not restricted to the embodiments shown as examples. The present disclosure includes above-described embodiments and modifications of the above-described embodiments made by a person skilled in the art. For example, the present disclosure is not limited to a combination of components and elements described in the embodiments, and various modifications may be implemented. The present disclosure may be implemented in various combinations thereof. The present disclosure may have additional components that can be added to the embodiments. The present disclosure encompasses the omission of parts and elements of the embodiments. The present disclosure encompasses replacement or combination of the parts and elements between one embodiment and another. The present disclosed technical scope is not limited to the description of the embodiments. The disclosed technical scope is indicated by the description of the claims, and should be construed to include all changes within the meaning and range equivalent to the description of the claims.

In each of the above-described embodiments, the housing such as the inverter housing 90 may be provided with peripheral fins such as the inverter fins 92 in any manner. At least one of the plurality of inverter fins 92 may be provided to correspond to a peripheral fin. Further, the first outer peripheral fins such as the first fin 921 and the second outer peripheral fins such as the second fin 922 may be provided in any manner on the housing. Of the plurality of first fins 921, at least one first fin 921 may be provided to correspond to the first outer peripheral fin. Of the plurality of second fins 922, at least one second fin 922 may be provided to correspond to the second outer peripheral fin. Further, at least a part of each of the outer peripheral fins, the first outer peripheral fins, and the second outer peripheral fins may be provided on the inverter upstream surface 911 and the inverter downstream surface 912.

In each of the above embodiments, the first outer peripheral fins and the second outer peripheral fins may have any shape. For example, in the first embodiment, the first fin 921 may be a shrink fin or a parallel fin. The second fin 922 may also be an expanded fin or a parallel fin. Further, the shapes of the multiple first outer peripheral fins do not have to be uniform. Similarly, the shapes of the second outer peripheral fins do not have to be uniform. In addition, the first outer peripheral fins and the second outer peripheral fins may be inclined in the circumferential direction CD with respect to the motor axis Cm.

In each of the above embodiments, the first and second outer peripheral fins may have any positional relationship as long as they extend in the axial direction AD from a position that overlaps in the radial direction RD with a heat generating portion such as the inverter unit 170. The first outer peripheral fin and the second outer peripheral fin need only be spaced apart in a direction perpendicular to the radial direction RD. For example, in the first embodiment, the first fin 921 and the second fin 922 only need to be spaced apart in the circumferential direction CD. In such configuration, a part of the first fin 921 and a part of the second fin 922 may be aligned in the circumferential direction CD. For example, the first downstream end 113 may be positioned downstream of the second upstream end 122. That is, the first flow path 131 and the second flow path 132 may be directly connected without the intermediation of the connecting flow path 133.

In each of the above-described embodiments, the relationship in size between the width dimension W1b of the first downstream end 113 and the width dimension W2a of the second upstream end 122 may be provided in any manner. For example, the width dimension W1b of the first downstream end 113 may be greater than the width dimension W2a of the second upstream end 122. Further, the size relationship between the first downstream port area S131b and the second upstream port area S132a may be provided in any manner. For example, the first downstream port area S131b may be greater than the second upstream port area S132a.

In each of the above embodiments, the fin interposer such as the duct fin 202 may have any shape. For example, in the fourth embodiment, the duct fin 202 may be plate-shaped and may extend in the circumferential direction CD. Further, the duct fins 202 may be formed in a cylindrical, prismatic, or tubular shape.

In each of the above embodiments, the fin interposer may be provided in any manner in the fin flow path 130. For example, in the fourth embodiment, the duct fins 202 may be provided on the inverter outer peripheral surface 910. In such configuration, the protrusions provided on the inverter outer peripheral surface 910 are the duct fins 202, which correspond to a fin interposer.

In each of the above-described embodiments, the surface-mount components may be provided in any manner inside the housing. For example, in the first embodiment, the capacitor component 176 and the filter component 177 may be provided as surface-mount components. Further, the heat generating portion does not need to have a surface-mount component. In such configuration, it is preferable that a plurality of heat-generating components such as switch components 175 are arranged along the inverter inner peripheral surface 913.

In each of the above embodiments, the outer peripheral fins may be the motor fins 72. For example, the motor device 60 may be provided upstream of the inverter device 80 with respect to the propeller wind Wp. In such configuration, the motor 61, the motor stator 62, the motor rotor 63, and the like correspond to a heat generating portion, and the motor housing 70 corresponds to a housing. The motor fins 72 are provided on the motor housing 70 to serve as peripheral fins.

In each of the above-described embodiments, the motor 61 and the inverter unit 170 may be housed in a common housing. For example, the common housing is a housing which is provided as an integrated object of the motor housing 70 and the inverter housing 90. The common housing is provided with peripheral fins. In the common housing, the motor 61 and the inverter unit 170 correspond to a heat generating portion.

In each of the above-described embodiments, the motor 61 may be not a dual-rotor motor. For example, the motor 61 may be a single-rotor motor including one rotor. The motor 61 may be not an axial gap-type motor. For example, the motor 61 may be a radial gap-type motor. In this motor 61, a motor stator 62 and a motor rotor 63 are arranged side by side in the radial direction RD.

In each of the above embodiments, the airflow of the propeller wind Wp may be generated in any manner. For example, the EPU 50 may be provided with a blower such as a fan that generates an airflow that flows in the axial direction AD. The blower may or may be not included in the EPU 50. In addition, the airflow flowing in the axial direction AD may be a flight wind generated as the eVTOL 10 flies.

In each of the above-described embodiments, the eVTOL 10 may be configured such that at least one propeller 20 is driven by at least one EPU 50. For example, one propeller 20 may be driven by multiple EPUs 50, or multiple propellers 20 may be driven by one EPU 50.

In each of the above-described embodiments, the flight vehicle on which the EPU 50 is mounted may be not the vertical take-off and landing flight vehicle as long as being of an electric type. For example, the flight vehicle may be a flight vehicle capable of taking off and landing while gliding, as an example of the electric flight vehicle. Further, the flight vehicle may be a rotary wing flight vehicle, or a fixed-wing flight vehicle. The flight vehicle may be an unmanned flight vehicle carrying no person.

In each of the above-described embodiments, the moving object on which the EPU 50 is mounted may be not a flight vehicle as long as the moving object is movable by rotation of a rotating body. For example, the moving object may be a vehicle, a ship, a construction machine, or an agricultural machine. For example, when the moving object is a vehicle, a construction machine, or the like, the rotating body is a wheel or the like for moving, and an output shaft is an axle or the like. When the moving object is a ship, the rotating body is a propulsion-screw propeller or the like, and the output shaft is a propeller shaft or the like.

The present disclosure provides multiple technical ideas described below as multiple items. Some items may be described in a multiple dependent form with subsequent items referring to the preceding item in alternative form. Further, some items may be described in a multiple dependent form referring to another multiple dependent form. These items described in a multiple dependent form define multiple technical ideas.

### (Technical idea 1)

A drive device (50) is configured to be driven by electric power. The drive device includes: a heat generating portion (170) configured to generate heat when energized; a housing (90) having an outer peripheral surface (910), which extends in an axial direction (AD), and accommodating the heat generating portion; and a plurality of outer peripheral fins (92) extending in the axial direction along the outer peripheral surface of the housing, arranged in a circumferential direction (CD) of the housing along the outer peripheral surface of the housing, and configured to dissipate heat from the heat generating portion to an outside of the housing. The outer peripheral surface in which, as a pair of ends aligned in the axial direction, a first surface end (910a) and a second surface end (910b). The peripheral fins include: a first outer peripheral fin (921, 921A) extending from a position, which is aligned with the heat generating portion in a radial direction (RD) of the housing, toward the first surface end among the first surface end and the second surface end; and a second outer peripheral fin (922, 922A) provided at a position spaced apart from the first outer peripheral fin in a direction perpendicular to the radial direction, the second outer peripheral fin extending from a position, which is aligned with the heat generating portion in the radial direction, toward the second surface end among the first surface end and the second surface end.

### (Technical idea 2)

The drive device according to technical idea 1, in which a distance (D1) between two of the first outer peripheral fins, which are adjacent to each other in the circumferential direction, gradually decreases toward the second surface end in the axial direction.

### (Technical idea 3)

The drive device according to technical idea 1 or 2, in which the first outer peripheral fin is an expanded fin (921) in which a circumferential width (W1) gradually expands toward the second surface end.

### (Technical idea 4)

The drive device according to any one of technical ideas 1 to 3, in which two of the first outer peripheral fins, which are adjacent to each other in the circumferential direction, therebetween define a first opposing port (131b), which is open toward the second surface end in the axial direction, two of the second outer peripheral fins, which are adjacent to each other in the circumferential direction, therebetween define a second opposing port (132a), which is open toward the first surface end in the axial direction, and the first opposing port and the second opposing port are aligned in the axial direction.

### (Technical idea 5)

The drive device according to technical idea 4 further includes: a fin interposer (202) extending in the radial direction. At least a part of the fin interposer is at a position between the first opposing port and the second opposing port, and the fin interposer is interposed at at least one of a position between two of the first outer peripheral fins, which are adjacent to each other in the circumferential direction, and a position between two of the second outer peripheral fins, which are adjacent to each other in the circumferential direction.

### (Technical idea 6)

The drive device according to technical idea 5 further includes: a duct part (201) provided to a radially outer side of the outer peripheral surface of the housing via the outer peripheral fins to cover the outer peripheral surface of the housing from the radially outer side and to form an outer circumferential flow path (130), which is configured to cause gas to flow between the duct part and the outer peripheral surface of the housing. The fin interposer extends in the radial direction from the duct part toward the outer peripheral surface of the housing.

### (Technical idea 7)

The drive device according to technical idea 5 or 6, in which the fin interposer is a tapered fin (202) in which a width in the circumferential direction gradually decreases toward the outer peripheral surface of the housing.

### (Technical idea 8)

The drive device according to any one of technical ideas 1 to 7, in which the first outer peripheral fin and the second outer peripheral fin are spaced apart from each other in the axial direction, the first outer peripheral fin has a first opposing end (113) that is an end on a side of the second surface end, the second outer peripheral fin has a second opposing end (122) that is an end on a side of the first surface end, and the first opposing end and the second opposing end are shifted from each other in the circumferential direction.

### (Technical idea 9)

The drive device according to any one of technical ideas 1 to 8, in which the first outer peripheral fin and the second outer peripheral fin are spaced apart from each other in the axial direction, the first outer peripheral fin has a first opposing end (113) that is an end on a side of the second surface end, the second outer peripheral fin has a second opposing end (122) that is an end on a side of the first surface end, the first opposing end and the second opposing end are aligned with each other in the axial direction, and in the circumferential direction, a width dimension (W2a) of the second opposing end is smaller than a width dimension (W1b) of the first opposing end.

### (Technical idea 10)

The drive device according to any one of technical ideas 1 to 9, in which the first outer peripheral fin and the second outer peripheral fin are spaced apart from each other in the axial direction, two of the first outer peripheral fins, which are adjacent to each other in the circumferential direction, therebetween define a first opposing port (131b), which is open toward the second surface end in the axial direction, the second outer peripheral fin has a second opposing end (122) that is an end on a side of the first surface end, and the second opposing end is at a position, which is aligned with the first opposing port in the axial direction.

### (Technical idea 11)

The drive device according to any one of technical ideas 1 to 10, in which the heat generating portion in which a plurality of surface-mount components (175) arranged in the circumferential direction along an inner peripheral surface (913) of the housing and provided to the inner peripheral surface of the housing, the first outer peripheral fin extends from a position, which is aligned with the surface-mount components in the radial direction, toward the first surface end, and the second outer peripheral fin extends from a position, which is aligned with the surface-mount components in the radial direction, toward the second surface end.

### (Technical idea 12)

The drive device according to any one of technical ideas 1 to 11, further includes: a motor (61) to be supplied with electric power; and an inverter unit (170) configured to convert electric power to be supplied to the motor. The axial direction is a direction in which a rotation axis (Cm) of the motor extends, and at least one of the motor and the inverter unit is, as the heat generating portion, housed in the housing.

### (Technical idea 13)

The drive device according to any one of technical ideas 1 to 12, in which the drive device is a rotary electric machine provided in a flight vehicle (10) and configured to drive to fly the flight vehicle.

## Claims

1. A drive device (50) configured to be driven by electric power, the drive device comprising:
a heat generating portion (170) configured to generate heat when energized;
a housing (90) having an outer peripheral surface (910), which extends in an axial direction (AD), and accommodating the heat generating portion; and
a plurality of outer peripheral fins (92) extending in the axial direction along the outer peripheral surface of the housing, arranged in a circumferential direction (CD) of the housing along the outer peripheral surface of the housing, and configured to dissipate heat from the heat generating portion to an outside of the housing, wherein
the outer peripheral surface includes, as a pair of ends aligned in the axial direction, a first surface end (910a) and a second surface end (910b), and
the peripheral fins include:
a first outer peripheral fin (921, 921A) extending from a position, which is aligned with the heat generating portion in a radial direction (RD) of the housing, toward the first surface end among the first surface end and the second surface end; and
a second outer peripheral fin (922, 922A) provided at a position spaced apart from the first outer peripheral fin in a direction perpendicular to the radial direction, the second outer peripheral fin extending from a position, which is aligned with the heat generating portion in the radial direction, toward the second surface end among the first surface end and the second surface end.

2. The drive device according to claim 1, wherein
a distance (D1) between two of the first outer peripheral fins, which are adjacent to each other in the circumferential direction, gradually decreases toward the second surface end in the axial direction.

3. The drive device according to claim 1, wherein
the first outer peripheral fin is an expanded fin (921) in which a circumferential width (W1) gradually expands toward the second surface end.

4. The drive device according to any one of claims 1 to 3, wherein
two of the first outer peripheral fins, which are adjacent to each other in the circumferential direction, therebetween define a first opposing port (131b), which is open toward the second surface end in the axial direction,
two of the second outer peripheral fins, which are adjacent to each other in the circumferential direction, therebetween define a second opposing port (132a), which is open toward the first surface end in the axial direction, and
the first opposing port and the second opposing port are aligned in the axial direction.

5. The drive device according to claim 4 further comprising:
a fin interposer (202) extending in the radial direction, wherein
at least a part of the fin interposer is at a position between the first opposing port and the second opposing port, and
the fin interposer is interposed at at least one of a position between two of the first outer peripheral fins, which are adjacent to each other in the circumferential direction, and a position between two of the second outer peripheral fins, which are adjacent to each other in the circumferential direction.

6. The drive device according to claim 5 further comprising:
a duct part (201) provided to a radially outer side of the outer peripheral surface of the housing via the outer peripheral fins to cover the outer peripheral surface of the housing from the radially outer side and to form an outer circumferential flow path (130), which is configured to cause gas to flow between the duct part and the outer peripheral surface of the housing, wherein
the fin interposer extends in the radial direction from the duct part toward the outer peripheral surface of the housing.

7. The drive device according to claim 5, wherein
the fin interposer is a tapered fin (202) in which a width in the circumferential direction gradually decreases toward the outer peripheral surface of the housing.

8. The drive device according to any one of claims 1 to 3, wherein
the first outer peripheral fin and the second outer peripheral fin are spaced apart from each other in the axial direction,
the first outer peripheral fin has a first opposing end (113) that is an end on a side of the second surface end,
the second outer peripheral fin has a second opposing end (122) that is an end on a side of the first surface end, and
the first opposing end and the second opposing end are shifted from each other in the circumferential direction.

9. The drive device according to any one of claims 1 to 3, wherein
the first outer peripheral fin and the second outer peripheral fin are spaced apart from each other in the axial direction,
the first outer peripheral fin has a first opposing end (113) that is an end on a side of the second surface end,
the second outer peripheral fin has a second opposing end (122) that is an end on a side of the first surface end,
the first opposing end and the second opposing end are aligned with each other in the axial direction, and
in the circumferential direction, a width dimension (D2a) of the second opposing end is smaller than a width dimension (D1b) of the first opposing end.

10. The drive device according to any one of claims 1 to 3, wherein
the first outer peripheral fin and the second outer peripheral fin are spaced apart from each other in the axial direction,
two of the first outer peripheral fins, which are adjacent to each other in the circumferential direction, therebetween define a first opposing port (131b), which is open toward the second surface end in the axial direction,
the second outer peripheral fin has a second opposing end (122) that is an end on a side of the first surface end, and
the second opposing end is at a position, which is aligned with the first opposing port in the axial direction.

11. The drive device according to any one of claims 1 to 3, wherein
the heat generating portion includes a plurality of surface-mount components (175) arranged in the circumferential direction along an inner peripheral surface (913) of the housing and provided to the inner peripheral surface of the housing,
the first outer peripheral fin extends from a position, which is aligned with the surface-mount components in the radial direction, toward the first surface end, and
the second outer peripheral fin extends from a position, which is aligned with the surface-mount components in the radial direction, toward the second surface end.

12. The drive device according to any one of claims 1 to 3, further comprising:
a motor (61) to be supplied with electric power; and
an inverter unit (170) configured to convert electric power to be supplied to the motor, wherein
the axial direction is a direction in which a rotation axis (Cm) of the motor extends, and
at least one of the motor and the inverter unit is, as the heat generating portion, housed in the housing.

13. The drive device according to any one of claims 1 to 3, wherein
the drive device is a rotary electric machine provided in a flight vehicle (10) and configured to drive to fly the flight vehicle.
